# FASCICULE DE BREVET EUROPEEN

(11) **EP 3 843 143 B1**
(45) Date de publication et mention de la délivrance du brevet: **29.06.2022**
(21) Numéro de dépôt: 20215749.1
(22) Date de dépôt: 18.12.2020
(51) Int. Cl.: H01L 27/24, H01L 29/06, H01L 29/423, H01L 29/786, H01L 21/336, H01L 45/00

(54) **MÉMOIRE 3D ET SON PROCÉDÉ DE FABRICATION**
3D-SPEICHER UND DESSEN HERSTELLUNGSVERFAHREN
3D MEMORY AND MANUFACTURING METHOD THEREOF

(30) Priorité: 23.12.2019 FR 1915473
(43) Date de publication de la demande: 30.06.2021
(73) Titulaire: Commissariat à l'Energie Atomique et aux Energies Alternatives, 75015 Paris (FR)
(72) Inventeur: BARRAUD, Sylvain, 38054 GRENOBLE CEDEX 09 (FR); ANDRIEU, François, 38054 GRENOBLE CEDEX 09 (FR)
(74) Mandataire: Hautier IP

(56) Documents cités:
- US-A1- 2013 153 851
- US-A1- 2017 271 402
- US-B1- 8 026 521

## Description

### DOMAINE TECHNIQUE

La présente invention se rapporte au domaine de la microélectronique et des mémoires et en particulier celui des mémoires résistives non-volatiles RRAM ou ReRAM (pour « Resistive random-access memory »).

### ÉTAT DE LA TECHNIQUE

Les mémoires RAM comprennent typiquement une matrice de cellules mémoires capables de stocker chacune une information binaire (bit), et un système d'adressage permettant de lire ou de modifier chaque bit d'information de chaque cellule mémoire.

Chaque cellule mémoire comprend ainsi un élément de commutation permettant de passer de la valeur 0 à la valeur 1 du bit. Cet élément de commutation, également appelé élément mémoire, est généralement disposé entre deux électrodes respectivement connectées à une ligne de données dite « bitline » et à une ligne de commande dite « wordline » du système d'adressage. Un transistor de sélection, commandé par la wordline et connecté à une ligne de source dite « sourceline » du système d'adressage, peut en outre être ajouté à la cellule mémoire de façon à optimiser la commutation de l'élément mémoire.

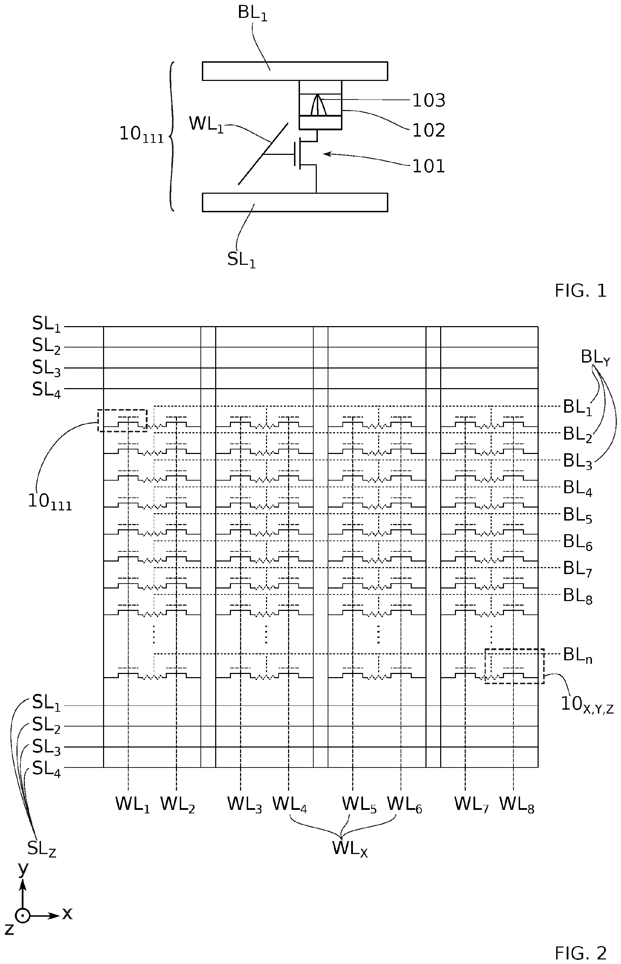

Les mémoires résistives RRAM ont pour principe commun de fonctionnement que leurs changements d'états sont dus à des changements de résistivité de l'élément mémoire. La figure 1 illustre un exemple de cellule mémoire RRAM de type OxRAM dans laquelle l'élément mémoire est un oxyde diélectrique, normalement isolant, qui peut être rendu conducteur par création de filaments ou d'un chemin de conduction dans ce matériau après l'application d'une tension ou d'un courant suffisant.

Pour augmenter la capacité de stockage des mémoires en limitant leur encombrement, une solution consiste à augmenter la densité de cellules mémoires au sein de la mémoire. Pour cela, des dispositifs dans lesquels des cellules mémoires sont réparties sur plusieurs niveaux superposés, sont apparus. Les documents US 2017/0092541 A1 et US 8 026 521 B1 décrivent par exemple une architecture 3D monolithique de mémoire résistive comprenant des cellules mémoires empilées et isolées les unes des autres. Cette architecture est réalisée à partir d'un empilement multicouches silicium/oxyde de silicium Si/SiO2. Cet empilement est structuré et une grille est déposée de façon à former des transistors. Les éléments mémoire sont formés sur les drains des transistors, et les différentes lignes de connexions wordline, sourceline et bitline sont respectivement créées au niveau des grilles et des sources des transistors, et des éléments mémoire. Des dispositifs de mémoire 3D similaires sont divulgués par US 2013/153851 A1 et US 2017/271402 A1, par exemple.

Le procédé de fabrication de cette architecture 3D monolithique est cependant cher et complexe. L'augmentation de densité de cellules mémoires dans cette architecture reste limitée. L'intensité du courant électrique circulant au sein des transistors est en outre relativement faible. Le contrôle électrostatique des transistors de sélection n'est pas optimisé.

La présente invention vise à pallier au moins en partie les inconvénients mentionnés ci-dessus.

En particulier, un objet de la présente invention est une architecture 3D de dispositif microélectronique présentant une densité d'intégration améliorée.

Un autre objet de la présente invention est une architecture 3D de dispositif microélectronique configurée pour améliorer le contrôle électrostatique des transistors.

Un autre objet de la présente invention est un procédé de fabrication d'une telle architecture 3D de dispositif microélectronique, réduisant le coût de fabrication.

### RÉSUMÉ

Pour atteindre ces objectifs, la présente invention propose selon un premier aspect un dispositif microélectronique comprenant au moins deux cellules mémoire comprenant chacune un transistor dit de sélection et un élément mémoire associé audit transistor de sélection, chaque transistor comprenant un canal sous forme de fil s'étendant principalement selon une première direction x, une grille bordant ledit canal et s'étendant principalement selon une deuxième direction y, une première région correspondant à l'un parmi une source ou un drain, et une deuxième région correspondant à l'autre parmi la source ou le drain, la deuxième région étant connectée à l'élément mémoire, lesdits transistors étant empilés selon une troisième direction z et occupant chacun un niveau n_{z} (z = 1...4) d'altitude donnée selon la troisième direction z.

Selon l'invention, pour chaque transistor, les première et deuxième régions sont entièrement couvertes par des espaceurs en projection selon la troisième direction z dans un plan xy. De tels espaceurs couvrant totalement, au moins selon la direction z, les première et deuxième régions, par exemple respectivement la source et le drain, permettent de diminuer l'encombrement du transistor selon la première direction. Dès lors, la densité d'intégration d'une architecture 3D comprenant de tels dispositifs microélectroniques est augmentée. Une telle architecture 3D peut notamment comprendre sur chaque niveau une pluralité de transistors selon les première et deuxième directions, et une pluralité de niveaux selon la troisième direction.

Selon un mode de réalisation qui peut être alternatif ou combiné aux caractéristiques du mode de réalisation du paragraphe précédent, pour au moins un transistor de sélection, la grille entoure totalement le canal. Une telle grille entourant totalement le canal, également dénommée GAA (acronyme de « Gate All Around »), permet d'améliorer le contrôle électrostatique dudit transistor. En particulier, l'intensité du courant drain-source peut être augmentée en conservant un bon contrôle de l'état passant ou bloquant du transistor. Cela permet ainsi d'apporter une solution efficace face à la problématique consistant à améliorer les performances des dispositifs microélectroniques comprenant une pluralité de cellules mémoire. On notera que l'on peut exploiter les caractéristiques du présent paragraphe indépendamment de celles du paragraphe précédent.

Selon un deuxième aspect, l'invention concerne également un système microélectronique comprenant une pluralité de dispositifs microélectroniques selon le premier aspect de l'invention. Ces dispositifs microélectroniques sont connectés entre eux de façon à ce que les transistors de deux dispositifs microélectroniques adjacents présentent une première région, par exemple une source, commune pour un même niveau et sont associés à deux éléments mémoire distincts, de façon à former une matrice de cellules mémoires.

Un tel système est avantageusement compact et compatible avec une intégration 3D dense.

Selon un troisième aspect, l'invention concerne également un procédé de fabrication d'un dispositif microélectronique comprenant au moins deux cellules mémoire comprenant chacune un transistor dit de sélection et un élément mémoire associé audit transistor de sélection, chaque transistor comprenant un canal sous forme de fil s'étendant principalement selon une première direction x, une grille bordant ledit canal et s'étendant principalement selon une deuxième direction y, une première région correspondant à l'un parmi une source ou un drain et une deuxième région correspondant à l'autre parmi la source ou le drain connectée à l'élément mémoire, lesdits transistors étant empilés principalement selon une troisième direction z et occupant chacun un niveau n_{z} (z = 1...4 par exemple) d'altitude donnée selon la troisième direction z.

Le procédé comprend les étapes suivantes :
- Former un empilement, selon la troisième direction (z), de couches alternées d'un premier matériau semiconducteur et d'un deuxième matériau diélectrique,
- Former à partir de cet empilement des ouvertures définissant des motifs de transistors comprenant chacun une partie centrale s'étendant principalement selon la première direction (x) et des première et deuxième parties périphériques, s'étendant de part et d'autre de la partie centrale, ladite partie centrale étant destinée à former le canal du transistor et lesdites première et deuxième parties périphériques étant destinées à former respectivement première et deuxième régions du transistor,
- Former des motifs de grilles en partie dans les ouvertures, à cheval sur les parties centrales des motifs de transistors et s'étendant principalement selon une deuxième direction (y) en bordure des premières parties périphériques,
- Former des espaceurs longitudinaux de part et d'autre des motifs de grilles, lesdits espaceurs longitudinaux couvrant entièrement les première et deuxième parties périphériques des motifs de transistors en projection selon la troisième direction (z) dans un plan (xy),
- Former les éléments mémoire de sorte que chaque élément mémoire présente un bord en alignement selon la troisième direction (z) avec un bord d'un espaceur longitudinal. Par exemple, chaque élément mémoire présente un flanc au contact d'un flanc d'un espaceur. Ces flancs s'étendent principalement ou en partie au moins selon le plan yz. Les éléments mémoire sont ainsi typiquement formés en bordure des espaceurs longitudinaux, au niveau des deuxièmes parties périphériques.
- Former les grilles des transistors à partir des motifs de grille.

Contrairement au procédé divulgué par le document US 2017/0092541 A1, l'utilisation d'espaceurs longitudinaux couvrant les première et deuxième parties périphériques (formant ultérieurement les première et deuxième régions des transistors) permet de contrôler précisément la distance entre l'élément mémoire et la grille du transistor de sélection qui lui est associé. Cela améliore la reproductibilité de la définition des éléments mémoire. Cela permet en outre d'améliorer la compacité de la cellule mémoire. Les éléments mémoire sont ainsi formés au plus près des grilles, séparés de celles-ci selon la première direction x uniquement par les espaceurs longitudinaux. Cela permet de densifier la matrice 3D de cellules mémoire ainsi formée.

Ce procédé permet donc d'obtenir une matrice 3D de cellules mémoires présentant une densité d'intégration élevée.

Selon une possibilité, la formation de l'empilement comprend les étapes suivantes :
- Former par épitaxie un empilement provisoire selon la troisième direction comprenant au moins deux couches semi-conductrices du premier matériau semiconducteur séparées par au moins une couche sacrificielle en un deuxième matériau semi-conducteur,
- Après formation des motifs de grilles et de préférence après formation des espaceurs longitudinaux autour des grilles, retirer l'au moins une couche sacrificielle à partir des ouvertures,
- Remplir par le deuxième matériau diélectrique un espace laissé par le retrait de l'au moins une couche sacrificielle, de façon à former au moins une couche diélectrique.

Les transistors à base du premier matériau ne sont dès lors pas isolés les uns des autres dès le début du procédé. Ils sont isolés a *posteriori,* lors du retrait du deuxième matériau effectué par exemple via une gravure sélective.

Au contraire, dans le document US 2017/0092541 A1, l'empilement de transistors isolés est directement formé par report de couches semi-conductrices sur des couches isolantes, en alternance. Un tel procédé de report est cher et complexe.

Dans la présente invention, le deuxième matériau peut être semi-conducteur. Il peut avantageusement servir de couche de germination pour l'épitaxie du premier matériau. Ainsi, les différentes couches peuvent être formées par croissance épitaxiale des premier et deuxième matériaux, sans report de couches.

La formation d'un tel empilement de couches des premier et deuxième matériaux, suivi d'un retrait du deuxième matériau et d'un remplissage par un matériau diélectrique visant à remplacer le deuxième matériau, permet donc d'obtenir *in fine* un empilement de couches semi-conductrices et isolantes avec un coût réduit. Cela permet en outre de conserver la structure cristalline, par exemple le caractère monocristallin, des couches semi-conductrices du premier matériau.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 illustre schématiquement une cellule mémoire résistive de type OxRAM.
La FIGURE 2 présente un schéma de conception, habituellement qualifié par son vocable anglais « design », d'une matrice de cellules mémoire selon un mode de réalisation de la présente invention.
La FIGURE 3 présente un plan d'un système microélectronique comprenant une matrice de cellules mémoire selon un mode de réalisation de la présente invention.
Les FIGURES 4A à 4G illustrent schématiquement en vue de perspective des étapes de fabrication des grilles sacrificielles d'un système microélectronique selon un premier mode de réalisation de la présente invention.
La FIGURE 5 illustre schématiquement en vue de perspective une étape de fabrication d'un système microélectronique selon un premier mode de réalisation de la présente invention.
Les FIGURES 6A à 6C illustrent schématiquement en vue de perspective des étapes de fabrication d'un système microélectronique selon un premier mode de réalisation de la présente invention.
Les FIGURES 7A et 7B illustrent respectivement des coupes transverses selon les axes AA' et BB' illustrés à la FIGURE 6C.
Les FIGURES 8A à 8D illustrent schématiquement en vue de perspective des étapes de fabrication d'un système microélectronique visant à isoler des sources de transistors entre elles, selon un premier mode de réalisation de la présente invention.
La FIGURE 9 présente une image STEM HAADF d'une partie d'un système microélectronique selon un premier mode de réalisation de la présente invention, en cours de fabrication.
Les FIGURES 10A et 10B illustrent une partie d'un système microélectronique selon un premier mode de réalisation de la présente invention, respectivement avant et après isolation des sources entre elles.
Les FIGURES 11A à 11D illustrent schématiquement en vue de perspective des étapes de fabrication de la zone des lignes de source d'un système microélectronique selon un premier mode de réalisation de la présente invention.
La FIGURE 12 est une vue schématique des sources et des canaux en silicium d'un système microélectronique selon un premier mode de réalisation de la présente invention.
Les FIGURES 13A à 13F illustrent schématiquement en vue de perspective des étapes de fabrication de la zone des lignes de mots d'un système microélectronique selon un premier mode de réalisation de la présente invention.
Les FIGURES 14A à 14C illustrent schématiquement des étapes d'un procédé de fabrication de la zone des lignes de données d'un système microélectronique selon un premier mode de réalisation de la présente invention.
La FIGURE 15 illustre schématiquement l'étape du procédé de fabrication illustrée à la FIGURE 14C selon une coupe longitudinale EE' représentée sur la FIGURE 14C.
Les FIGURES 16A à 16D illustrent schématiquement des étapes d'un procédé de fabrication de la zone des lignes de source d'un système microélectronique selon un premier mode de réalisation de la présente invention, pour la réalisation de contacts en escalier.
Les FIGURES 17A et 17B illustrent schématiquement des étapes d'un procédé de fabrication d'un système microélectronique selon un premier mode de réalisation de la présente invention.
La FIGURE 18 illustre schématiquement en vue de perspective un système microélectronique selon un premier mode de réalisation de la présente invention.
Les FIGURES 19 à 22 illustrent schématiquement en vue de perspective des étapes de fabrication d'un système microélectronique selon un deuxième mode de réalisation de la présente invention.
Les FIGURES 23 à 28 illustrent schématiquement des étapes d'un procédé de fabrication de la zone des lignes de source d'un système microélectronique selon un deuxième mode de réalisation de la présente invention, pour la réalisation de contacts en escalier.
Les FIGURES 29 à 33 illustrent schématiquement en vue de perspective des étapes de fabrication des grilles sacrificielles d'un système microélectronique selon un deuxième mode de réalisation de la présente invention.
Les FIGURES 34 à 39 illustrent schématiquement en vue de perspective des étapes de fabrication d'un système microélectronique visant à isoler des sources de transistors entre elles, selon un deuxième mode de réalisation de la présente invention.
Les FIGURES 40 à 45 illustrent schématiquement des étapes d'un procédé de fabrication de la zone des lignes de source d'un système microélectronique selon un deuxième mode de réalisation de la présente invention
Les FIGURES 46 à 49 illustrent schématiquement des étapes d'un procédé de fabrication de la zone des lignes de mots d'un système microélectronique selon un deuxième mode de réalisation de la présente invention.
Les FIGURES 50 à 55 illustrent schématiquement des étapes d'un procédé de fabrication de la zone des lignes de données d'un système microélectronique selon un deuxième mode de réalisation de la présente invention
Les FIGURES 56 et 57 illustrent schématiquement un système microélectronique selon un deuxième mode de réalisation de la présente invention, respectivement selon une coupe transverse XZ et selon une coupe longitudinale YZ.
Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions des différentes structures (couches, motifs) ou zones ne sont pas représentatives de la réalité.

### DESCRIPTION DÉTAILLÉE

Avant d'entamer une revue détaillée de modes de réalisation de l'invention, il est rappelé que, de manière facultative, l'invention comprend au moins l'une quelconque des caractéristiques optionnelles suivantes qui peuvent être utilisées en association ou alternativement.

Selon l'invention, les première et deuxième régions sont entièrement couvertes par des espaceurs en projection selon la troisième direction z dans un plan xy.

Selon un exemple, la grille entoure totalement le canal d'au moins un transistor de sélection. Cette grille enrobante permet d'obtenir une architecture de transistor de sélection dite « Gate All Around ». Un tel transistor présente un contrôle électrostatique amélioré.

Selon un exemple, pour chaque transistor, éventuellement hormis le transistor dont le canal est situé au niveau d'altitude le plus bas selon la troisième direction z, la grille entoure totalement le canal.

Selon un exemple, le dispositif mémoire comprend au moins trois et de préférence au moins quatre transistors empilés selon la troisième direction z. Cela permet d'augmenter encore la densité du dispositif mémoire.

Selon un exemple, lesdits espaceurs sont situés au droit, c'est-à-dire à l'aplomb, des première et deuxième régions selon la troisième direction z.

Selon un exemple, l'élément mémoire présente une résistivité variable, de façon à former des cellules mémoires résistives, par exemple de type OxRAM.

Selon un exemple, les grilles des transistors sont connectées électriquement entre elles et les premières régions des transistors sont isolées électriquement entre elles. Des premières régions indépendantes correspondant aux sources des transistors permettent d'alimenter indépendamment les transistors. Cela permet par exemple d'exécuter des opérations de lecture ou d'écriture sur chaque niveau indépendamment.

Selon un exemple, les grilles des transistors sont connectées électriquement entre elles dans une zone de lignes de mots du système microélectronique.

Selon un exemple du système microélectronique, les premières régions des transistors de deux niveaux différents sont isolées électriquement entre elles.

Selon un exemple, le système microélectronique comprend au moins trois et de préférence au moins six dispositifs mémoires disposés de manière parallèles selon la première direction x.

Selon un exemple, les premières régions, typiquement les sources, occupant différents niveaux sont connectées en escalier, indépendamment les unes des autres, dans une zone de lignes de source. Cela permet d'alimenter les transistors et/ou les points mémoire de façon indépendante sur chaque niveau de la matrice de cellules mémoire.

Selon un exemple, le procédé comprend en outre des gravures en escalier dans une zone de lignes de source, de façon à atteindre les premières régions, typiquement les sources, des différents niveaux. Selon un exemple, le procédé comprend en outre la formation de contacts en escalier sur les premières régions des différents niveaux.

Selon un exemple, le premier matériau semi-conducteur est du silicium et le deuxième matériau semi-conducteur est un alliage de silicium-germanium.

Selon un exemple, la formation des grilles comprend les étapes suivantes :
- Retirer les motifs de grille également dénommés grilles sacrificielles de façon à dégager entièrement les canaux formés dans les parties centrales des motifs de transistors,
- Déposer un matériau diélectrique de grille puis un matériau métallique de grille autour desdits canaux de façon à former des grilles dites enrobantes entourant totalement au moins un canal parmi lesdits canaux.

Selon un exemple, l'au moins une couche diélectrique comprend des portions restantes de l'au moins une couche sacrificielle au niveau des parties centrales des transistors entre les canaux des transistors et ces portions restantes sont retirées après le retrait des motifs de grille et avant formation des grilles.

Selon un exemple, la formation des éléments mémoire au niveau des deuxièmes régions est guidée par des espaceurs transverses s'étendant principalement dans un plan normal à la direction d'extension principale des espaceurs longitudinaux. Cela permet de former des points mémoires « auto-alignés » avec les deuxièmes régions, typiquement les drains des transistors. Les contraintes de lithographie sont ainsi relâchées.

Selon un exemple, le procédé comprend les étapes suivantes :
- Former sur un substrat s'étendant selon des première et deuxième directions un empilement selon une troisième direction comprenant au moins deux couches en un premier matériau semi-conducteur séparées par au moins une couche sacrificielle en un deuxième matériau semi-conducteur, chaque couche en un premier matériau semi-conducteur définissant un niveau d'altitude donnée selon la troisième direction,
- Former des motifs de transistors par gravure anisotrope selon la troisième direction de zones de l'empilement, lesdits motifs comprenant au moins deux transistors empilés selon la troisième direction z, chacun de ces transistors étant à base du premier matériau et comprenant un canal sous forme de fil s'étendant selon la première direction x, une source s'étendant selon la deuxième direction y, et un drain,
- Remplir lesdites zones par un matériau de grille sacrificielle,
- Former des grilles sacrificielles par gravure anisotrope selon la troisième direction d'une partie seulement dudit matériau de grille sacrificielle, lesdites grilles sacrificielles s'étendant sur un premier côté des sources des transistors, à cheval sur les canaux des transistors,
- Former des espaceurs longitudinaux de part et d'autre des grilles sacrificielles, lesdits espaceurs longitudinaux s'étendant principalement selon la deuxième direction y et étant destinés à couvrir entièrement les sources et les drains des transistors en projection selon la troisième direction z dans un plan xy,
- Former des première et deuxième ouvertures de part et d'autre desdits espaceurs longitudinaux et à l'aplomb des espaceurs longitudinaux selon la troisième direction z, les premières ouvertures exposant les drains de transistors et les deuxièmes ouvertures exposant un deuxième côté des sources,
- Graver partiellement l'au moins une couche sacrificielle sélectivement par rapport aux couches en un premier matériau semi-conducteur, à partir desdites première et deuxième ouvertures,
- Remplir par un matériau diélectrique un espace laissé par la gravure partielle de l'au moins une couche sacrificielle, de façon à isoler les sources entre elles et les drains entre eux,
- Retirer les grilles sacrificielles de façon à exposer le premier côté des sources et les canaux des transistors,
- Graver l'au moins une couche sacrificielle sélectivement par rapport aux couches en un premier matériau semi-conducteur, à partir des emplacements de grilles sacrificielles retirées, de façon à dégager les canaux des transistors,
- Déposer un matériau diélectrique de grille puis un matériau métallique de grille autour des canaux des transistors, de façon à former des grilles enrobant les canaux des transistors,
- Former les éléments mémoire au niveau des drains des transistors.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif. En particulier, le nombre de niveaux de l'empilement peut être supérieur à 4, voire supérieur à 10. Le nombre et/ou la forme des ouvertures dans l'empilement, les motifs de transistors illustrés sur les figures peuvent varier et être combinés de manière à former un autre mode de réalisation qui n'est pas nécessairement illustré ou décrit. Un tel mode de réalisation n'est évidemment pas exclu de l'invention.

Par ailleurs, sauf incompatibilité, il est entendu que le dispositif, le système microélectronique, et le procédé de fabrication peuvent comprendre, *mutatis mutandis,* l'ensemble des caractéristiques optionnelles présentées dans la présente demande.

La présente invention trouve pour domaine préférentiel d'application l'intégration 3D de systèmes micro-électroniques exécutant des fonctions logiques et de mémoire.

La présente invention prévoit notamment de réaliser une architecture 3D comprenant une forte densité de nanofils superposés sur différents niveaux. Cette architecture 3D est notamment configurée pour connecter électriquement chaque nanofil de façon indépendante. Chaque nanofil est de préférence entouré par une grille enrobante de façon à obtenir un transistor GAA. Cette grille se prolonge du côté source des transistors et est bordée par des espaceurs longitudinaux. Ces espaceurs couvrent les sources et les drains des différents transistors.

Il est précisé que dans le cadre de la présente invention, le terme « sur », « surmonte », « recouvre » ou « sous-jacent » ou leurs équivalents ne signifient pas « au contact de ». Ainsi par exemple, la présence d'un espaceur ou d'une couche sur ou qui recouvre un élément structurel, ne signifie pas obligatoirement que l'espaceur ou que la couche sont directement au contact de l'élément structurel mais cela signifie que l'espaceur ou que la couche recouvre au moins partiellement l'élément structurel en étant soit directement à son contact, soit en étant séparée de celui-ci par au moins une autre couche, canal, ou tout autre élément.

On entend par un élément structurel, une couche, « à base » d'un matériau A, un élément structurel, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat.

Sauf indication contraire, sur les figures, la hauteur et la profondeur sont prises selon l'axe z du repère orthonormé xyz.

Un élément situé au droit ou à l'aplomb d'un autre élément signifie que ces deux éléments sont situés tous deux sur une même ligne normale au plan de base du substrat, i.e. sur une même ligne orientée verticalement selon z sur les figures.

Un élément « bordant » un autre élément signifie que cet élément entoure partiellement ou totalement l'autre élément. Sauf mention explicite, ce terme s'entend d'un recouvrement partiel.

Les termes « sensiblement », « environ », « de l'ordre de » signifient « à 10% près » ou, lorsqu'il s'agit d'une orientation angulaire, « à 10° près » et de préférence « à 5° près ». Ainsi, une direction sensiblement normale à un plan signifie une direction présentant un angle de 90±10° par rapport au plan.

Pour déterminer la géométrie et la disposition des différents éléments constitutifs d'un dispositif (tel qu'un transistor ou une cellule mémoire) ou d'un système microélectronique (tel qu'une mémoire résistive de type OxRAM), on peut procéder à des analyses de microscopie électronique, en particulier de Microscopie Electronique à Balayage (MEB) ou de Microscopie Electronique en Transmission (MET ou TEM).

Les compositions chimiques des différents éléments ou couches peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de couches ou d'éléments de faibles dimensions. Elle peut être mise en œuvre sur des coupes métallurgiques au sein d'un MEB ou d'un MET.

Ces techniques permettent notamment de déterminer si les caractéristiques de transistors ou de cellules mémoires formés dans une architecture 3D correspondent à celles des dispositifs ou systèmes décrits dans le cadre de la présente invention.

Ces techniques permettent également de suivre les différentes étapes mises en œuvre par un procédé de fabrication de transistors ou de cellules mémoires en intégration 3D, par exemple au travers d'analyses sur des prélèvements de dispositifs en cours de fabrication. L'utilisation de couches sacrificielles et de grilles sacrificielles peut notamment être un indice de mise en œuvre du procédé selon l'invention.

L'invention va maintenant être décrite au travers de deux exemples de réalisation d'une mémoire résistive de type OxRAM. Ces deux exemples sont organisés en deux sections respectivement dénommées « Exemple 1 » et « Exemple 2 ». Les étapes de fabrication d'une mémoire selon ces exemples sont subdivisées en sous-sections respectivement dénommées « formation des grilles sacrificielles », « isolation des sources », « structuration de la zone sourcelines », « structuration de la zone wordlines », « structuration de la zone bitlines », « formation des contacts ». Ces sous-sections sont définies par souci de clarté et ne sont pas nécessairement strictement successives.

La figure 2 présente un schéma fonctionnel d'une telle mémoire résistive OxRAM, formée à partir d'une pluralité de cellules mémoires 10_{x,y,z} comprenant chacune un élément résistif et un transistor. Ces cellules mémoires 10_{x,y,z} sont également dénommées cellules 1T1R. En pratique une cellule mémoire peut comporter quatre points mémoire et quatre transistors de sélection.

Les cellules mémoires 10_{x,y,z} sont typiquement organisées de façon matricielle sur différents niveaux d'intégration. Un niveau d'intégration est situé à une altitude z donnée selon l'axe Z. Les cellules mémoires 10_{x,y,z} sont ainsi repérées par leurs coordonnées x et y pour un niveau z donné.

Afin d'adresser indépendamment chaque cellule mémoire 10_{x,y,z} de cette matrice 3D, des lignes de connexion sont dessinées. Chaque cellule mémoire 10_{x,y,z} est ainsi connectée à une ligne d'alimentation ou d'écriture dite sourceline SL_{z}, une ligne de commande ou de mots dite wordline WLₓ, et une ligne de lecture ou de données dite bitline BL_{y}.

Dans ces exemples, les sourcelines sont portées par les niveaux z, les wordlines s'étendent selon Y et les bitlines s'étendent selon X. Pour chaque cellule mémoire, l'élément résistif est relié à une bitline BL_{y}, la source du transistor est reliée à une sourceline SL_{z}, et la grille du transistor est reliée à une wordline WLₓ. Les wordlines WL_{1,} WL₂, WL₃, WL₄, WL₅, WL₆, WL₇, WL₈ sont par exemple au nombre de 8 (x = [1...8]), de façon à encoder une information sur 8 bits. Les niveaux portant les sourcelines SL₁, SL₂, SL₃, SL₄ sont par exemple au nombre de 4 (z = [1...4]) et nommés dans la suite n1, n2, n3, n4 ou, par contraction, niveaux SL₁, SL₂, SL₃, SL₄. Les bitlines BL₁, BL₂, BL₃, BL₄, BL₅, BL₆, BL₇, BL₈ sont par exemple au nombre de 8 (y = [1...8]), ou plus (y = [1... n]), en fonction du format logique requis pour la mémoire. Le nombre limité de cellules mémoires 10_{x,y,z} de ces exemples permet d'illustrer les caractéristiques principales de l'invention de façon claire et concise. Ces exemples n'excluent pas d'autres possibilités d'organisation de la matrice 3D.

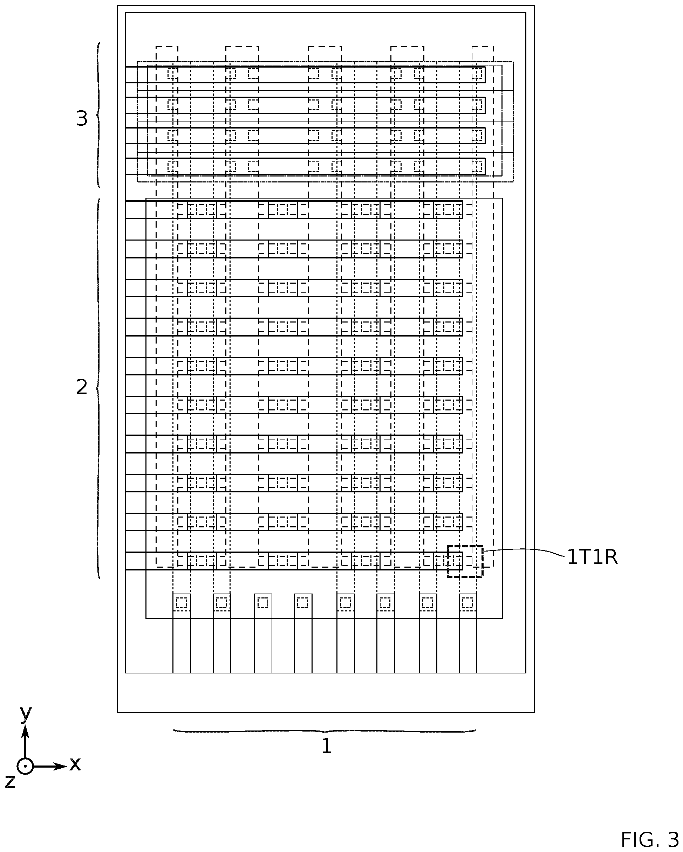

La figure 3 présente un exemple d'agencement des éléments structurels de la mémoire résistive OxRAM. Les cellules mémoires 1T1R forment une matrice dans le plan XY au croisement de la zone de wordlines 1 et de la zone de bitlines 2. Cet agencement peut comprendre une zone de sourcelines 3 déportée, jouxtant la matrice, de façon à faciliter la connexion des sourcelines.

Les éléments structurels de cette mémoire résistive sont principalement les transistors ou transistors de sélection, les éléments mémoires ou points mémoire, et les lignes de connexions wordlines, bitlines, sourcelines.

Selon l'invention, les transistors 101 sont empilés sur plusieurs niveaux d'intégration (selon l'axe z). Ces niveaux n₁, n₂, n₃, n₄ comprennent notamment les sources 1002 des transistors. Ils sont isolés électriquement les uns par rapport aux autres par l'intermédiaire d'une étape de formation de grilles sacrificielles 150. Ces grilles sacrificielles 150 sont ensuite remplacées par des grilles fonctionnelles enrobantes, de type GAA. Ce principe général permet d'obtenir une matrice 3D de transistors GAA dense. Dans les exemples illustrés et décrits ci-dessous, des zones de wordlines 1, bitlines 2 et sourcelines 3 sont également définies et des éléments mémoires 102 résistifs sont formés de façon à obtenir une mémoire OxRAM dense en intégration 3D.

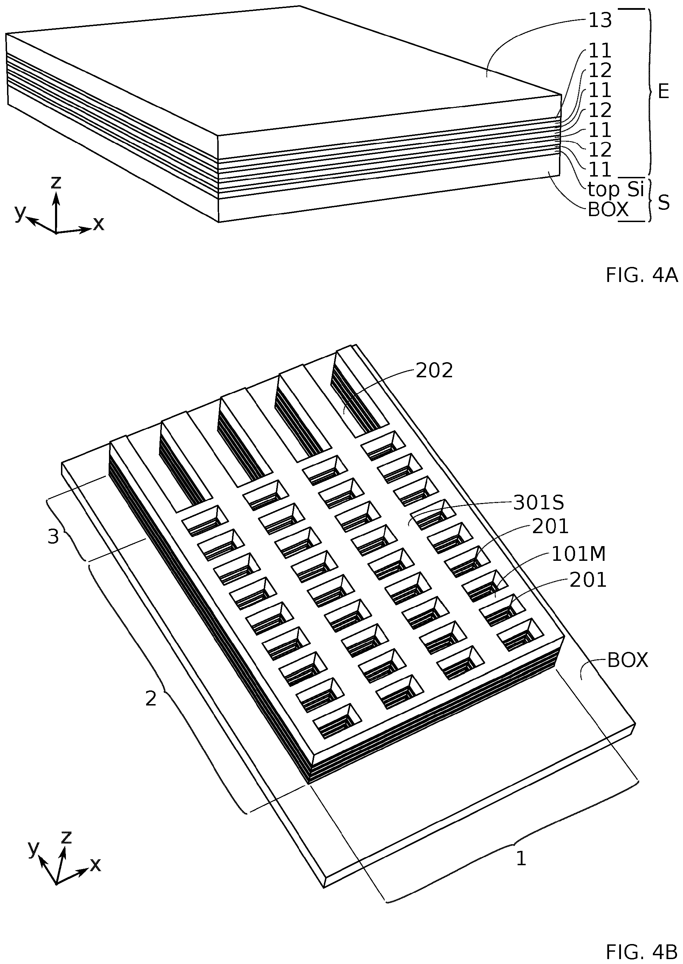

Un premier exemple de réalisation d'une mémoire résistive de type OxRAM va maintenant être décrit en référence aux figures 4A à 18 dans la section suivante :

### Exemple 1

### Formation des grilles sacrificielles

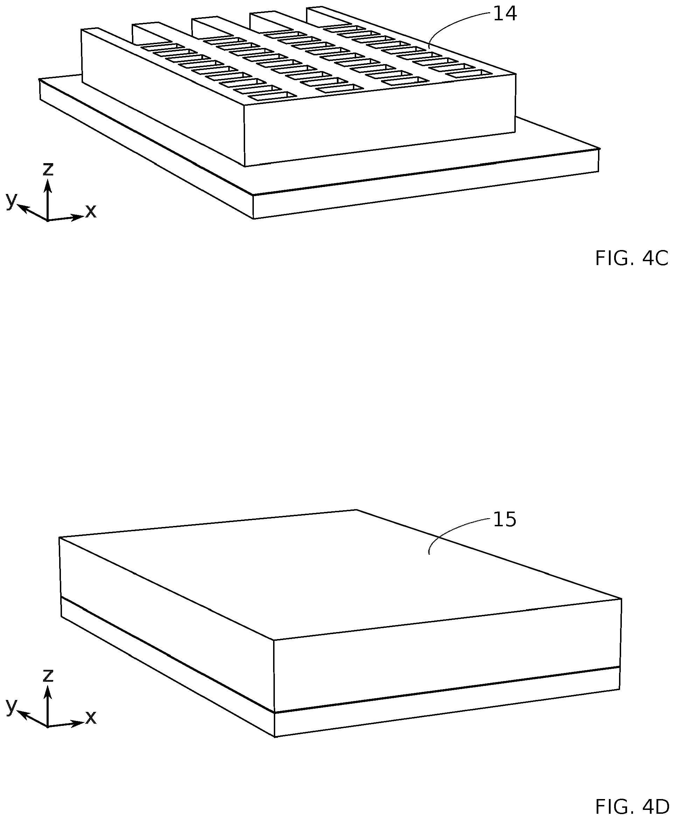

Les figures 4A et 4B illustrent la formation de l'empilement et la définition des motifs de transistors. Les figures 4C à 4G illustrent des étapes de formation des grilles sacrificielles au niveau des motifs de transistors.

Comme illustré à la figure 4A, une première étape consiste à réaliser un empilement E de couches semi-conductrices 11, 12 sur un substrat S. Le substrat S peut être un substrat de type SOI (Silicon On Insulator) comprenant, selon la terminologie courante pour l'homme du métier, une couche de silicium épaisse dite « Si bulk » (non représentée sur la figure 4A), une couche d'oxyde de silicium dite « BOX » (Burried Oxide) et une couche de silicium mince dite « top Si ». L'épaisseur du top Si peut être typiquement de l'ordre de 12nm. L'épaisseur du BOX peut être typiquement comprise entre 25nm et 145nm. Alternativement, le substrat S peut être un substrat massif « Si bulk ». Alternativement, le substrat est de type GeOI ou SGOI (respectivement Germanium On Insulator ou Silicon-Germanium On Insulator) connu de l'homme du métier. Dans ce dernier cas, la couche au contact du BOX est une couche sacrificielle en SiGe. Cela permet *in fine* de former des transistors présentant tous une configuration GAA, sur chaque niveau.

L'empilement E comprend typiquement une alternance de couches 11 en silicium-germanium (SiGe) et de couches 12 en silicium (Si).

La concentration du Ge dans l'alliage SiGe peut être de 20%, 30% ou 45% par exemple. Cette concentration de germanium est choisie de façon à permettre une bonne sélectivité de la gravure du SiGe par rapport au Si, lors des étapes de gravure sélective. Plus la concentration de Ge sera importante, plus la sélectivité au Si sera grande lors du retrait ultérieur du SiGe. Cet empilement E est avantageusement formé par épitaxie des couches de SiGe 11 et de Si 12. Cette étape de formation de l'empilement E est peu coûteuse et bien connue de l'homme du métier. Les épaisseurs des couches Si et SiGe peuvent être typiquement de l'ordre de 15nm, et plus généralement comprises entre 5nm et 50nm par exemple. De façon connue afin d'éviter la formation de défauts structuraux, les épaisseurs maximales permises pour les couches 11 SiGe dépendent notamment de la concentration en Ge choisie.

Dans l'exemple illustré à la figure 4A, quatre couches de Si (la couche top Si du substrat et trois couches Si 12 épitaxiées) sont alternées avec quatre couches de SiGe 11 épitaxiées. Un super réseau Si/SiGe est ainsi obtenu. Le nombre de couches de Si et de SiGe peut naturellement être augmenté. Cela permet *in fine* d'augmenter le nombre de transistors et de cellules mémoires.

Une couche de masque dur 13, de préférence en nitrure de silicium SiN, est ensuite déposée sur le super réseau Si/SiGe.

Tel qu'illustré à la figure 4B, une étape classique de lithographie/gravure est réalisée afin de définir des motifs de transistors 101M, des motifs de sources 301S et des ouvertures 201, 202. La gravure est anisotrope. Elle est configurée pour graver le super réseau Si/SiGe sur toute sa hauteur, en s'arrêtant sur le BOX. Elle peut être effectuée par plasma en utilisant une chimie de gravure HBr/O2. Les motifs de transistors 101M peuvent présenter une longueur I_{T} selon X comprise entre 100 nm et 500 nm. Ils présentent de préférence une largeur L_{T} selon Y comprise entre 10 nm et 80 nm, par exemple de l'ordre de 40 nm. Cela permet d'obtenir une pluralité de nanofils de Si superposés et destinés à former les canaux des transistors.

Les ouvertures 202 dans la zone sourcelines 3 sont significativement plus larges que les ouvertures 201 de la matrice définie par les zones wordlines 1 et bitlines 2. Cela permet de réserver des emplacements suffisamment larges pour la formation ultérieure des contacts de sourcelines, en particulier pour des contacts sourcelines en escalier.

Les figures 4C et 4D illustrent respectivement des étapes de dépôt d'une couche 14 d'oxyde de silicium SiO2 et d'une couche 15 de silicium polycristallin (polySi). Le SiO2 est de préférence un oxyde stœchiométrique déposé par CVD, dit TEOS du nom du précurseur de silicium (TetraEthyl OrthoSilicate) généralement utilisé. Ce dépôt est conforme. L'épaisseur de SiO2 déposé peut typiquement être de quelques nanomètres, par exemple 7 nm. Le polySi est déposé de façon à remplir les ouvertures 201, 202. L'épaisseur de polySi déposé peut typiquement être de quelques centaines de nanomètres, par exemple 380 nm. Ces dépôts successifs forment un empilement SiO2/polySi s'apparentant à un empilement de grille classique. La structuration de cet empilement permet de former des pseudo-grilles dénommées grilles sacrificielles dans cette demande. Ces grilles sacrificielles sont en effet conservées lors d'étapes intermédiaires de fabrication des dispositifs, puis retirées pour être finalement remplacées par des grilles fonctionnelles. Selon une possibilité alternative, le polySi peut être remplacé par un silicium amorphe.

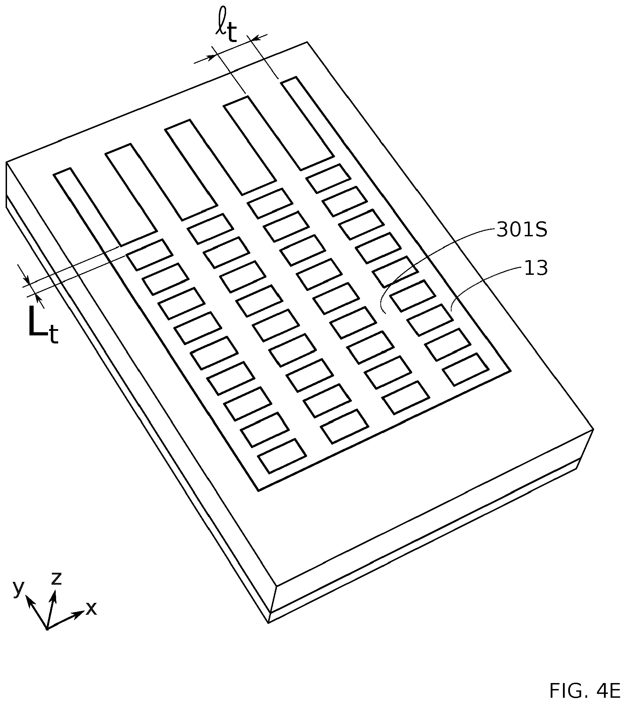

La figure 4E illustre une étape de planarisation, typiquement par polissage mécano-chimique CMP, configurée pour être arrêtée sur le masque dur 13.

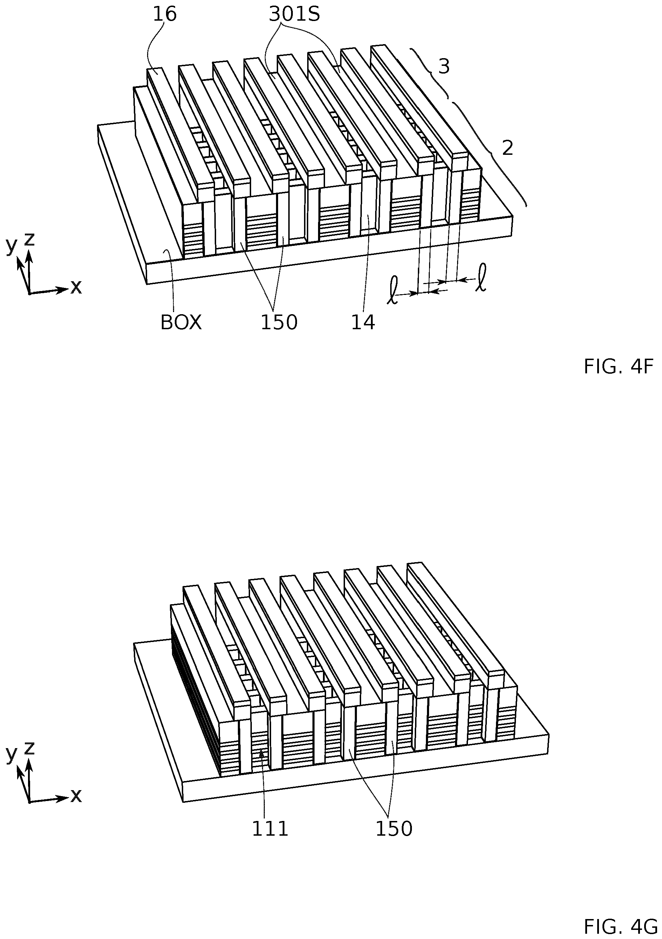

Un autre masque dur 16 peut ensuite être déposé sur toute la surface de la plaque, couvrant le masque dur 13 et le polySi exposé à l'issue de la planarisation (non illustré). Ce masque dur 16 comprend par exemple une couche de nitrure de silicium SiN d'épaisseur 90 nm environ surmontée d'une couche d'oxyde de silicium d'épaisseur 36 nm environ. Le masque dur 16 est structuré par lithographie/gravure de façon à définir les grilles sacrificielles. Le masque dur 16 couvre ainsi des portions de motifs de transistors 101M directement liées aux motifs de sources 301S (figure 4F). Ces portions de motifs de transistors 101M sont dites périphériques. Elles présentent de préférence une dimension I selon X comprise entre 10 nm et 150 nm, par exemple 50 nm. Cette dimension I peut être proportionnelle à la longueur I_{T} des motifs de transistors 101M, par exemple I = k.I_{T} avec 0.1 ≤ k ≤ 0.4.

Les grilles sacrificielles 150 sont formées entre les portions périphériques, par gravure anisotrope du polySi en dehors des zones couvertes par le masque dur 16, tel qu'illustré à la figure 4F.

La gravure anisotrope du polySi selon Z peut être effectuée par plasma, par exemple en chimie CH2F2 / SF6 / N2 / He et/ou HBr / O2 / He. La couche 14 de TEOS et l'oxyde enterré (BOX) servent avantageusement de couche d'arrêt lors de cette gravure du Poly-Si. Les grilles sacrificielles 150 de dimension I selon X sont ainsi formées dans les zones « bitline » 2 et « sourceline » 3. Dans la zone bitline 2, les grilles sacrificielles 150 s'étendent entre les motifs de transistors. Elles bordent de part et d'autre, selon Y, les portions périphériques situées à chaque extrémité des motifs de transistors. Dans la zone sourceline 3, les grilles sacrificielles 150 s'étendent de façon continue selon Y.

La figure 4G illustre le retrait de la couche 14 d'oxyde TEOS, après gravure du polySi. Ce retrait permet d'exposer une portion centrale 111 des motifs de transistors, entre les portions périphériques 112.

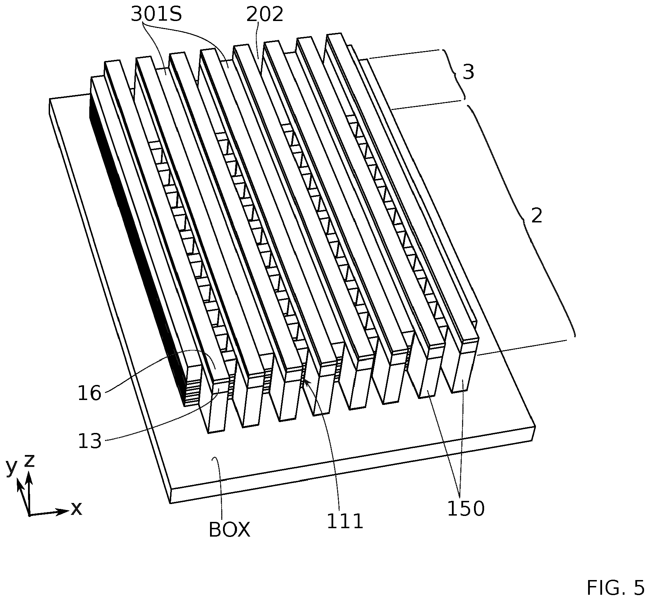

La figure 5 illustre la zone bitline 2 dans laquelle se trouvent les portions centrales 111 des motifs de transistors exposées, et la zone sourceline 3 dans laquelle les ouvertures 202 sont bordées par les grilles sacrificielles 150.

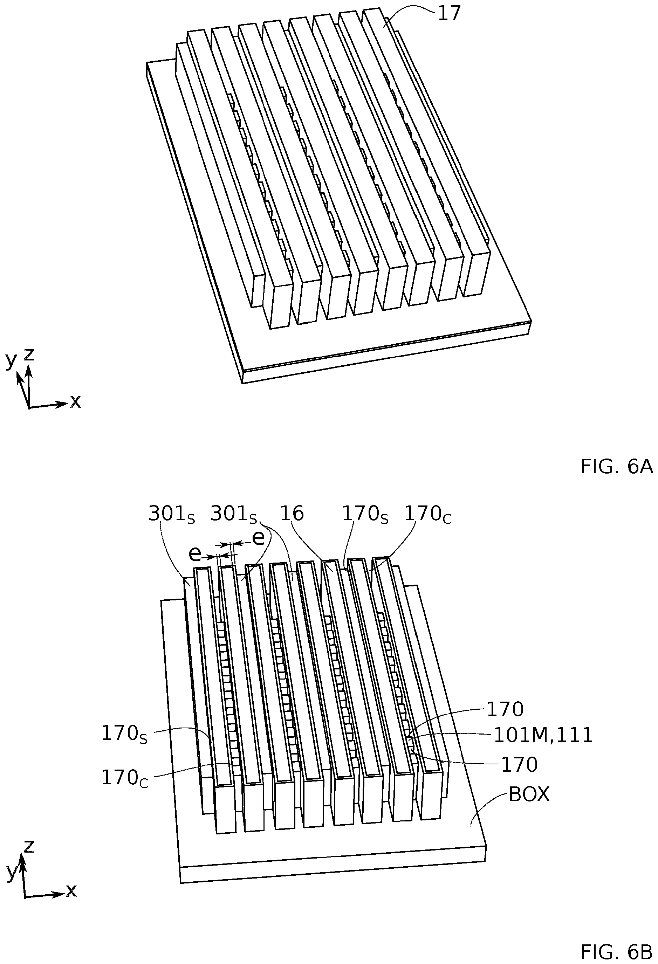

Les figures 6A et 6B illustrent la formation d'espaceurs 170, 170_{C}, 170_{S}. Les espaceurs 170_{C}, 170_{S} s'étendent principalement selon y de part et d'autres des grilles sacrificielles 150. Ces espaceurs 170_{C}, 170_{S} sont dits longitudinaux. Les espaceurs 170 s'étendent principalement selon x de part et d'autres des motifs de transistors 101M. Ces espaceurs 170 sont dits transverses. Les espaceurs 170, 170_{C}, 170_{S} sont typiquement formés à partir d'un dépôt d'une couche 17 de SiN (figure 6A) conforme suivi d'une gravure anisotrope de cette couche 17 de SiN (figure 6B). L'épaisseur e de la couche de SiN peut être comprise entre 10 nm et 50 nm, par exemple de l'ordre de 20 nm. A l'issue de la gravure des espaceurs, le masque dur 16 et le BOX sont exposés. Les espaceurs 170_{C}, 170_{S} présentent une largeur selon X égale à e et couvrent les flancs du masque dur 16. Les motifs de sources 301S sont ainsi en partie couverts par ces espaceurs 170_{S} sur leurs côtés bordant les masques durs 16. Les espaceurs 170_{S} forment sur les côtés des motifs de sources 301S une surépaisseur de SiN visant à protéger l'empilement Si/SiGe lors d'une gravure ultérieure. Les espaceurs 170_{c} couvrent les portions périphériques 112 de motifs de transistors 101M. Les espaceurs 170 couvrent les flancs des portions centrales 111 de motifs de transistors 101M.

Les parties de la couche de SiN s'étendant dans des plans parallèles au plan de base XY, entre les espaceurs verticaux, sont ensuite ouvertes par une première gravure anisotrope, par exemple par plasma en utilisant une chimie fluorocarbonnée, par exemple à base de CH2F2 / O2 ou CH3F/O2 et CHF3. Une telle première gravure anisotrope est connue de l'homme du métier. L'empilement Si/SiGe sous-jacent aux parties ouvertes est ensuite gravé sur toute sa hauteur, avec arrêt sur la couche d'oxyde enterré (BOX), par une deuxième gravure anisotrope, par exemple par plasma en utilisant une chimie HBr/O2.

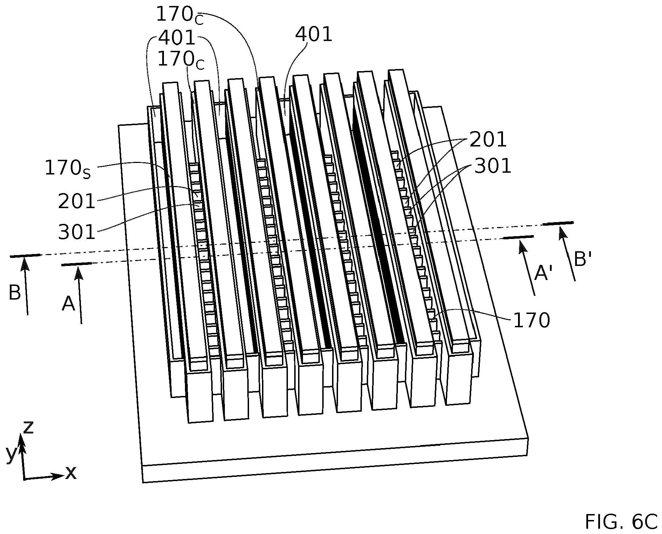

La figure 6C illustre la structure obtenue après ces première et deuxième gravures anisotropes. En particulier, les motifs de sources 301S ont été partiellement gravés et laissent place à des ouvertures 401 bordées par les empilements Si/SiGe surmontés des espaceurs 170_{S}. Les portions centrales 111 des motifs de transistors 101M ont été gravées et laissent place à des ouvertures 301 bordées par les espaceurs 170, 170_{C}. Ces ouvertures 301 débouchant sur les portions périphériques des motifs de transistors sont avantageusement délimitées par les espaceurs 170, 170_{C}. Cela permet de relâcher les contraintes de résolution en lithographie pour remplir ultérieurement ces ouvertures 301.

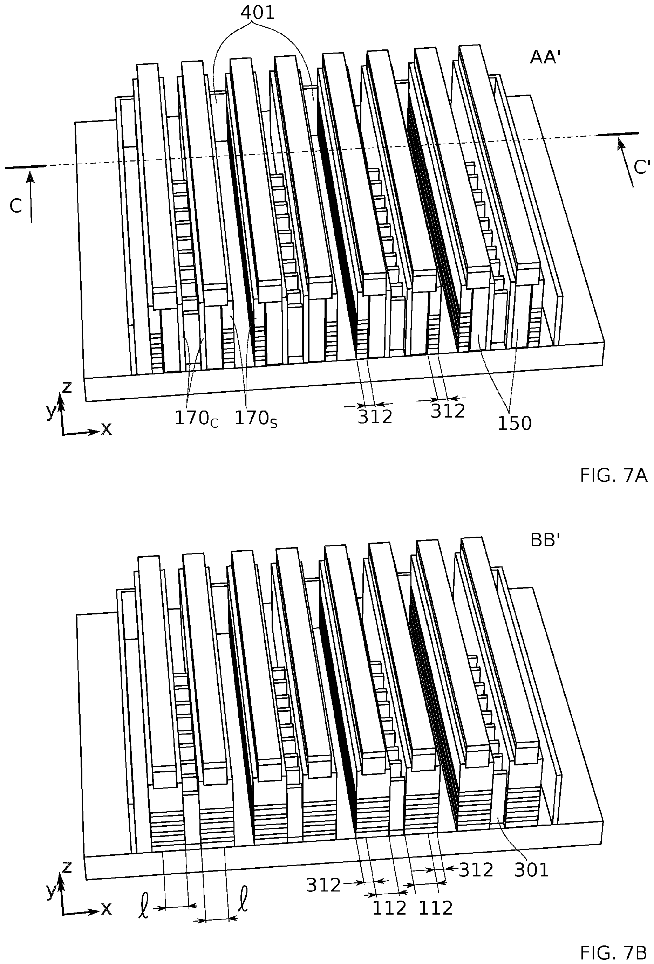

Deux coupes transverses dans la structure illustrée en figure 6C sont présentées aux figures 7A et 7B.

La figure 7A montre une coupe transverse passant au travers d'ouvertures 201, selon la ligne AA' matérialisée sur la figure 6C. Cette coupe transverse est similaire à une coupe transverse passant au travers d'ouvertures 401 (non illustrée). Il apparaît que les grilles sacrificielles 150 forment une série de piliers permettant un ancrage latéral des multicouches Si/SiGe ainsi structurés en « peigne ». Les portions périphériques 312 des motifs de sources 301S sont continues le long de l'axe Y. Un premier côté de ces portions périphériques 312 débouche sur les ouvertures 401. Un deuxième côté de ces portions périphériques 312 est attaché aux grilles sacrificielles 150. Préférentiellement, les couches Si de ces portions périphériques 312 formeront ultérieurement les sources des transistors.

La figure 7B montre une coupe transverse passant au travers d'ouvertures 301, selon la ligne BB' matérialisée sur la figure 6C. Les dents du « peigne » correspondent aux portions périphériques 112 des motifs de transistors 101M, de longueur I selon X. Préférentiellement, les couches Si de ces portions périphériques 112 formeront ultérieurement les canaux et les drains des transistors.

### Isolation des sources

Afin de pouvoir adresser indépendamment chacun des transistors de la matrice 3D, il est nécessaire d'isoler au moins en partie les transistors entre eux. Ces transistors sont formés à partir des couches Si de l'empilement Si/SiGe. Les couches SiGe sont donc de préférence retirées et remplacées par des couches électriquement isolantes. Les couches SiGe sont dites sacrificielles. Elles sont utilisées pour la formation de l'empilement puis retirées pour isoler les transistors, et en particulier les sources de ces transistors.

Avantageusement, une étape d'isolation des sources alimentant les canaux des transistors est effectuée. Ces sources sont formées à partir des couches Si des portions périphériques 312 des motifs de sources 301S illustrées aux figures 7A, 7B.

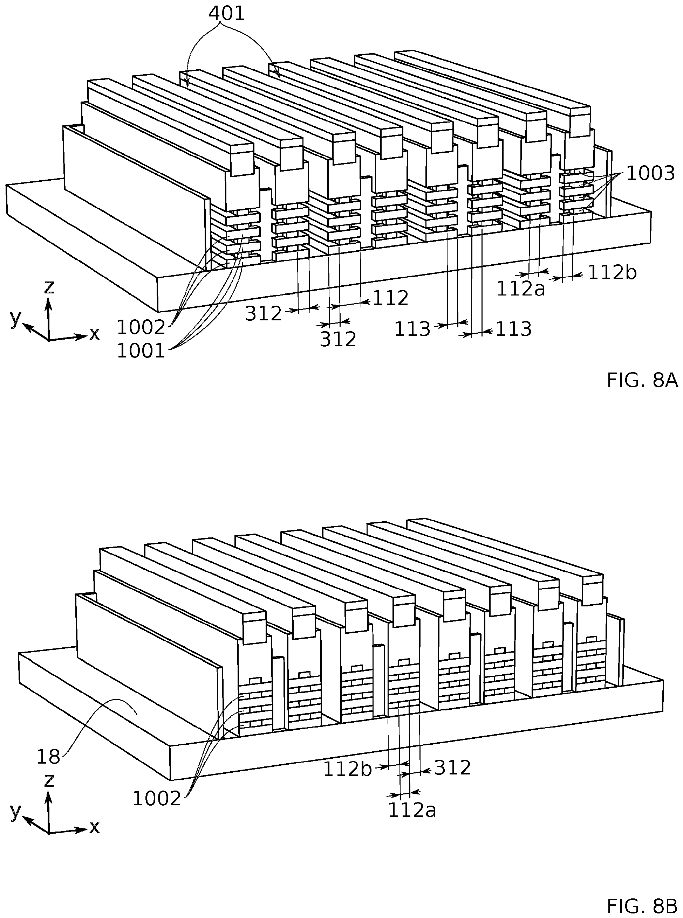

Tel qu'illustré à la figure 8A, des portions des couches SiGe de l'empilement sont gravées à partir des ouvertures 301, 401. Cette gravure est sélective vis-à-vis du silicium, et de préférence isotrope. Une solution de gravure à base d'acide acétique, d'acide fluorhydrique HF et d'eau oxygénée H2O2 peut être utilisée.

La gravure est configurée de manière à ce que les couches SiGe des portions périphériques 312 soient gravées au travers des ouvertures 401. Le front de gravure à partir des ouvertures 401 s'arrête ainsi sensiblement à l'aplomb des grilles sacrificielles 150. Les sources 1002 sont dès lors suspendues.

La gravure des couches SiGe s'effectue de préférence également au travers des ouvertures 301. La gravure sélective des couches SiGe se fait ainsi de part et d'autre de l'empilement, au niveau des motifs de transistors, tel qu'illustré à la figure 8A. Des parties 113 de couches SiGe des portions périphériques 112 sont ainsi gravées. La gravure est de préférence arrêtée au temps avant que les couches SiGe soient totalement retirées. Des portions 1003 de SiGe sont ainsi conservées. Les portions périphériques 112 sont ainsi subdivisées en parties 112a, 112b. Les parties 112a comprennent les futurs canaux 1001 en Si alternés avec les portions 1003 en SiGe. Les parties 112b comprennent les futurs drains 1006 en Si suspendus. La définition des drains 1006 et des canaux 1001 peut ainsi se faire lors de cette étape de gravure partielle du SiGe. Cette gravure partielle permet également d'éviter un risque d'effondrement des canaux 1001 de transistors.

Les grilles sacrificielles en Poly-Si permettent notamment de maintenir les couches Si lors de la gravure SiGe. Elles forment une structure de piliers d'accroché pour les couches Si.

La figure 8B illustre le dépôt d'une couche 18 diélectrique, par exemple SiN, destinée à remplir les cavités formées par le retrait du SiGe. Les sources 1002 sont ainsi isolées électriquement entre elles.

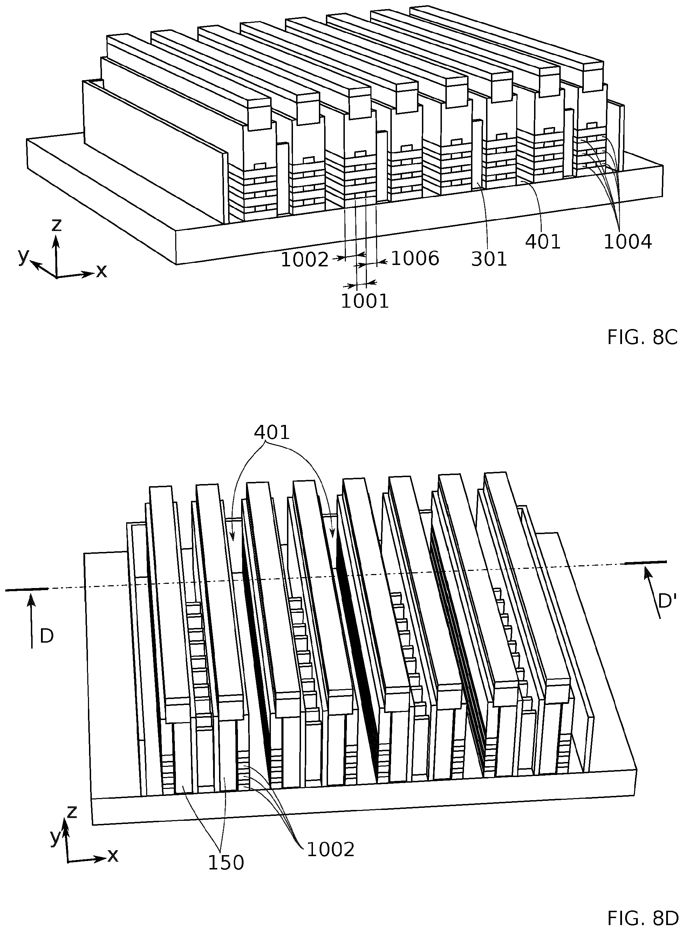

La couche 18 est ensuite partiellement gravée, par exemple à l'aide d'une solution d'acide phosphorique H3PO4 dilué ou d'acide acétique H2O2, de façon à exposer les flancs sensiblement parallèles au plan YZ des couches Si, du côté des ouvertures 401 et du côté des ouvertures 301. Le BOX est de préférence également exposé lors de cette gravure de la couche 18, tel qu'illustré à la figure 8C. Les figures 8A à 8C illustrent ces étapes de retrait du SiGe et d'isolation des sources selon une coupe transverse passant par les ouvertures 301.

La figure 8D illustre l'état de la structure après ces étapes de retrait du SiGe et d'isolation des sources selon une coupe transverse passant par les ouvertures 201. Il apparaît clairement que les grilles sacrificielles 150 servent de support aux sources 1002.

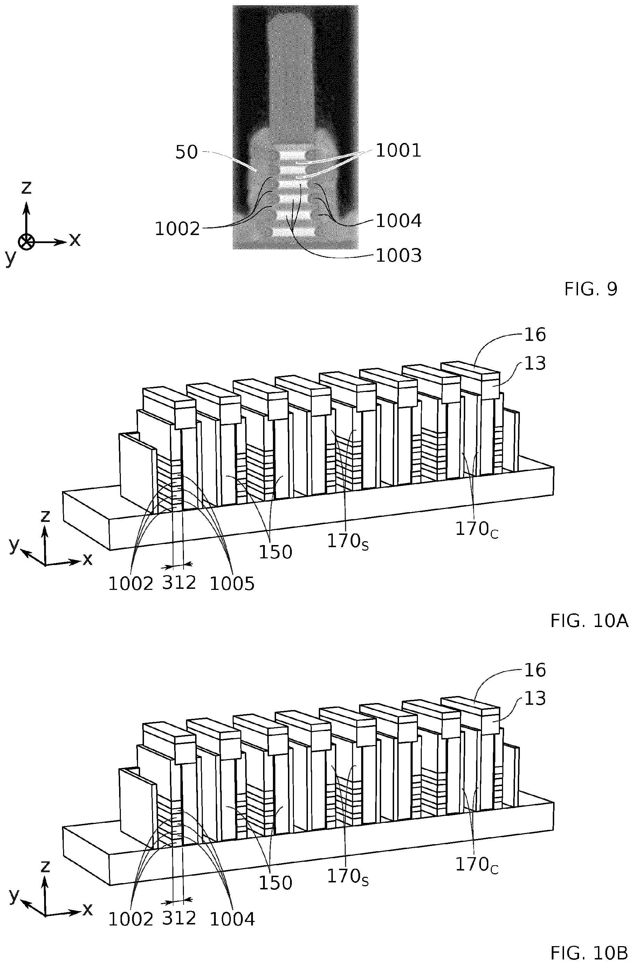

La figure 9 est une image de microscopie électronique à balayage en transmission (STEM) illustrant un dispositif obtenu après isolation des sources 1002, tel que schématisé à la figure 8C.

Les portions de SiGe 1003 restants sont visibles entre les canaux 1001 des transistors. Les bouchons 1004 formés par le dépôt de la couche SiN 18 sont également visibles de part et d'autre des portions SiGe 1003. La couche 50 est une épitaxie réalisée pour d'autres besoins. Les figures 10A et 10B présentent des agrandissements de la structure obtenue respectivement avant et après isolation. Ainsi, la figure 10A illustre de façon agrandie une coupe transverse selon la ligne CC' représentée sur la figure 7A, passant au travers des ouvertures 401 de la zone sourceline. La figure 10B illustre de façon agrandie une coupe transverse selon la ligne DD' représentée sur la figure 8D, passant au travers des ouvertures 401 de la zone sourceline.

Les grilles sacrificielles 150, les espaceurs 170_{C}, 170_{S}, les masques durs 13 et 16, et les sources 1002 sont visibles sur les deux figures 10A, 10B. Les portions SiGe 1005 des portions périphériques 312 des motifs de sources 301S présentes avant isolation (figure 10A) sont remplacées par les bouchons SiN 1004 dans les portions périphériques 312 des motifs de sources 301S après isolation (figure 10B).

### Structuration de la zone sourcelines

Après isolation des sources 1002, les ouvertures 401, 301, 201 entre les lignes de masque dur 16 sont remplies de préférence par un oxyde TEOS 180. La structure est ensuite planarisée par CMP jusqu'à retrait du masque dur 16, de façon à exposer le masque dur 13.

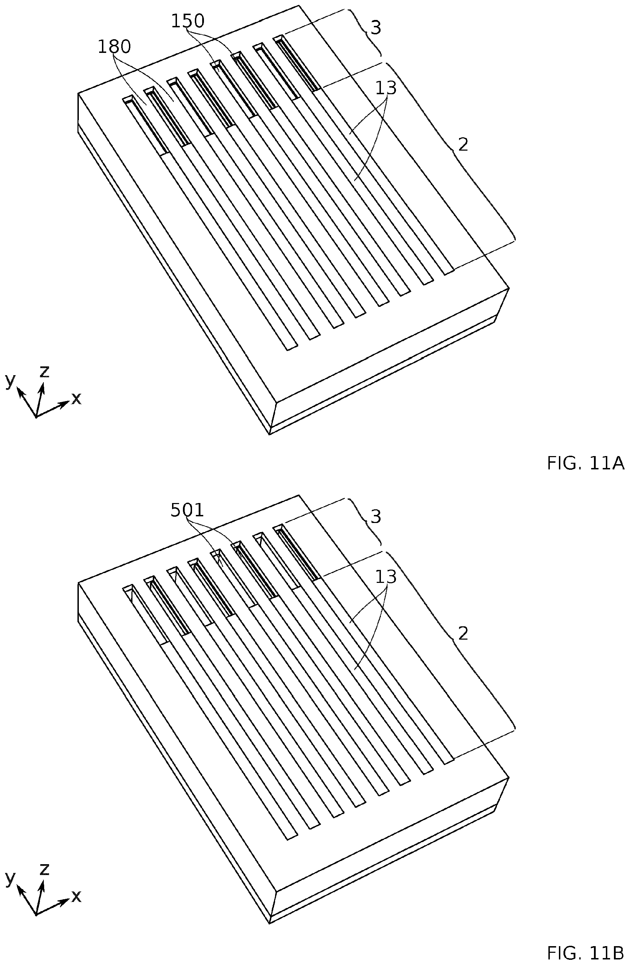

Par une étape de lithographie / gravure classique, ce masque dur 13 peut alors être retiré dans la zone sourceline 3, de façon à exposer le polySi des grilles sacrificielles 150, tel qu'illustré à la figure 11A. Le masque dur 13 SiN peut être gravé à l'aide d'une solution d'acide phosphorique H3PO4 dilué, ou par gravure sèche plasma à base d'espèces fluorocarbonnées (par exemple CH2F2/O2).

Les grilles sacrificielles 150 de la zone sourceline 3 sont ensuite retirées, tel qu'illustré à la figure 11B. Le polySi des grilles sacrificielles peut être gravé à l'aide d'une solution d'hydroxyde de tétraméthylammonium (TMAH) ou d'hydroxyde de tétraéthylammonium (TEAH). L'oxyde TEOS des grilles sacrificielles peut être gravé à l'aide d'un plasma en chimie fluorocarbonnée, par exemple en chimie CF₄ / CH₂F₂/ He.

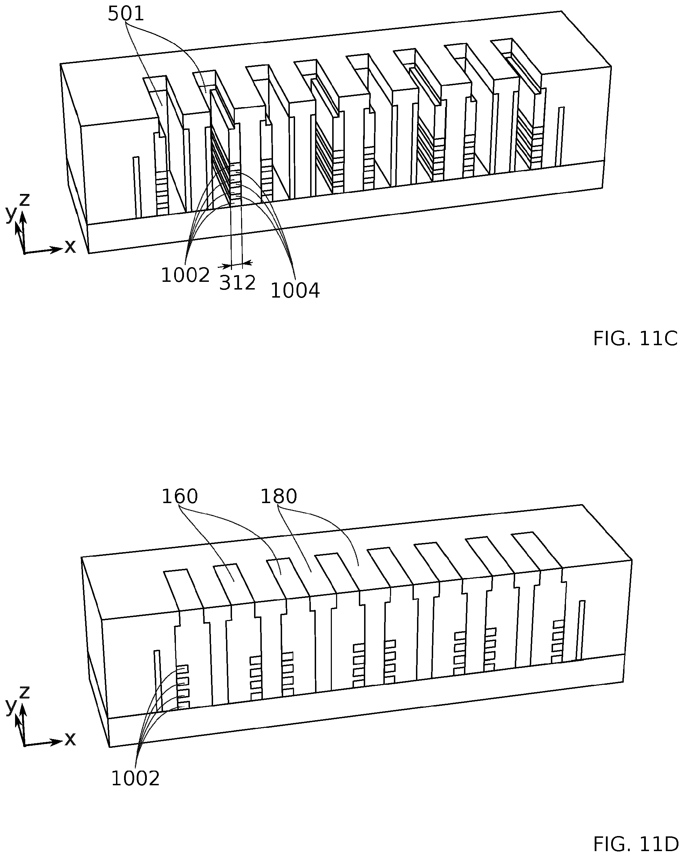

Dans l'exemple illustré à la figure 11C, le retrait des grilles sacrificielles 150 forme des ouvertures 501. Ces ouvertures 501 exposent le deuxième côté des portions périphériques 312 comprenant l'empilement des sources 1002 isolées entre elles par les bouchons de SiN 1004. Les grilles sacrificielles ont ainsi permis de former un support aux sources 1002 lors du remplacement des portions de SiGe 1005 par les bouchons de SiN 1004 dans les portions périphériques 312. Pour des portions SiGe 1005 présentant une largeur selon X inférieure ou égale à 100 nm, ce remplacement peut se faire en une seule étape tel qu'illustré précédemment par les figures 7A à 8D.

En revanche, si les portions SiGe 1005 présentent une largeur selon X supérieure à 100 nm, par exemple 150 nm ou 200 nm, le retrait complet de ces portions 1005 peut induire un effondrement ou collage des sources 1002 les unes sur les autres. Dans ce cas, un retrait partiel des portions 1005 sur une largeur selon X inférieure à 100 nm peut d'abord être effectué à partir des ouvertures 401 débouchant sur le premier côté des portions périphériques 312 (non illustré). Puis, après retrait des grilles sacrificielles, un retrait complémentaire des portions 1005 sur une largeur selon X restante peut être effectué à partir des ouvertures 501 débouchant sur le deuxième côté des portions périphériques 312. Dans ce cas, les grilles sacrificielles forment d'abord un support lors du premier retrait partiel du SiGe intercalé entre les sources, puis, en les retirant, ces grilles sacrificielles permettent un accès pour le deuxième retrait complémentaire du SiGe intercalé entre les sources. Ce remplacement en deux étapes par l'intermédiaire des grilles sacrificielles permet par exemple de dimensionner les sources de façon à ce qu'elles présentent une largeur comprise entre 1 fois et 2 fois la largeur critique d'effondrement des sources, i. e. la largeur au-delà de laquelle les sources sont susceptibles de s'effondrer.

Après retrait des grilles sacrificielles dans la zone sourceline 3, les ouvertures 501 sont remplies de préférence par un dépôt de SiN 160. Ce dépôt est suivi d'une planarisation par CMP avec arrêt sur la couche d'oxyde TEOS 180, tel qu'illustré à la figure 11D.

Les sources 1002 sont ainsi complètement isolées entre elles dans les zones sourceline 3.

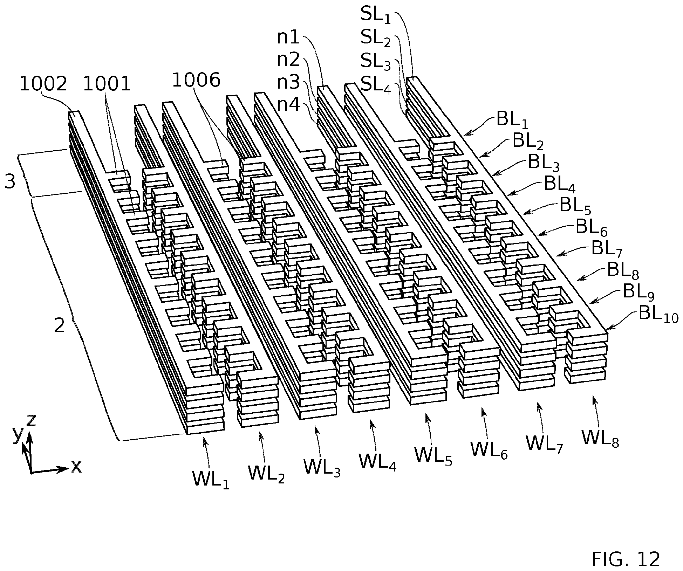

La figure 12 montre uniquement les éléments à base de Si de la structure. Les sources 1002 desservant les canaux 1001 de transistors dans la zone bitline 2, sous forme de peignes, sont ainsi clairement visibles. Ce « squelette » de silicium peut notamment permettre de former une matrice 3D comprenant 8 wordlines WL_{1,} WL₂, WL₃, WL₄, WL₅, WL₆, WL₇, WL₈, 4 niveaux n1, n2, n3, n4 de sourcelines SL₁, SL₂, SL₃, SL₄ et 10 bitlines BL₁, BL₂, BL₃, BL₄, BL₅, BL₆, BL₇, BL₈, BL₉, BL₁₀.

### Structuration de la zone wordlines

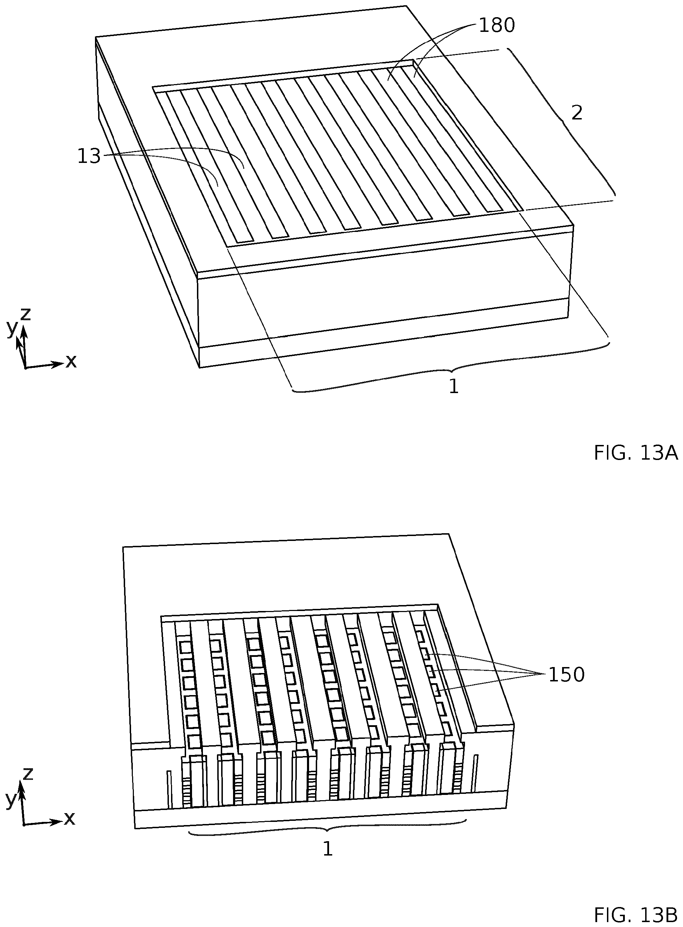

La figure 13A illustre un masquage, par exemple par lithographie, permettant de protéger la zone sourceline 3 tout en exposant la zone wordlines 1. Dans la suite, les WL sont réalisées au niveau des lignes de masque dur 13.

Tel qu'illustré à la figure 13B, une gravure du masque dur 13 est effectuée de manière à exposer le polySi des grilles sacrificielles 150 de la zone wordlines 1. Cette gravure du masque dur 13 en SiN peut se faire par plasma, par exemple à l'aide d'une chimie de plasma CH2F2/O2, ou CHF₃/He et CH₃F/O₂/He/CH₄.

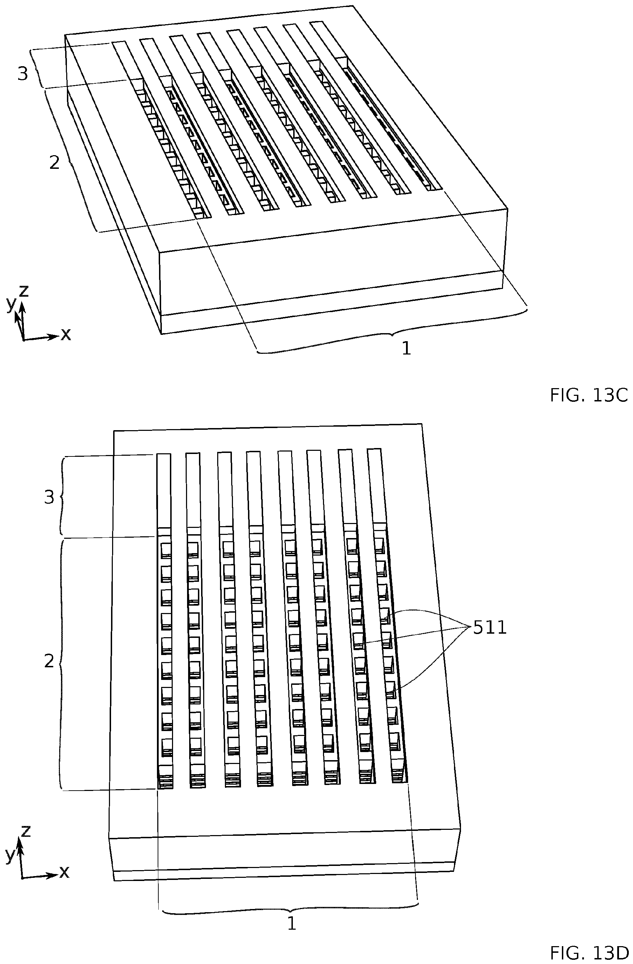

Les grilles sacrificielles 150 de la zone wordlines 1 sont ensuite retirées, tel qu'illustré aux figures 13C, 13D. Le polySi des grilles sacrificielles peut être gravé à l'aide d'une solution d'hydroxyde de tétraméthylammonium (TMAH) ou d'hydroxyde de tétraéthylammonium (TEAH) (figure 13C). L'oxyde TEOS des grilles sacrificielles peut être gravé à l'aide d'un plasma en chimie fluorocarbonnée, par exemple en chimie CF₄ / CH₂F₂ / He (figure 13D).

Dans l'exemple illustré à la figure 13D, le retrait des grilles sacrificielles 150 forme des ouvertures 511. Ces ouvertures 511 sont bordées par deux portions périphériques 112 de motifs de transistors 101M, un premier côté de portions périphériques 312 comprenant l'empilement des sources 1002 isolées entre elles, et un espaceur 170_{C} (non visible).

Les portions périphériques 112 de motifs de transistors 101M comprennent ici chacune une partie 112a formée d'un empilement de nanofils en Si entre lesquels se trouvent des portions 1003 de SiGe, et une partie 112b formée d'un empilement de nanofils en Si entre lesquels se trouvent des bouchons 1004 de SiN.

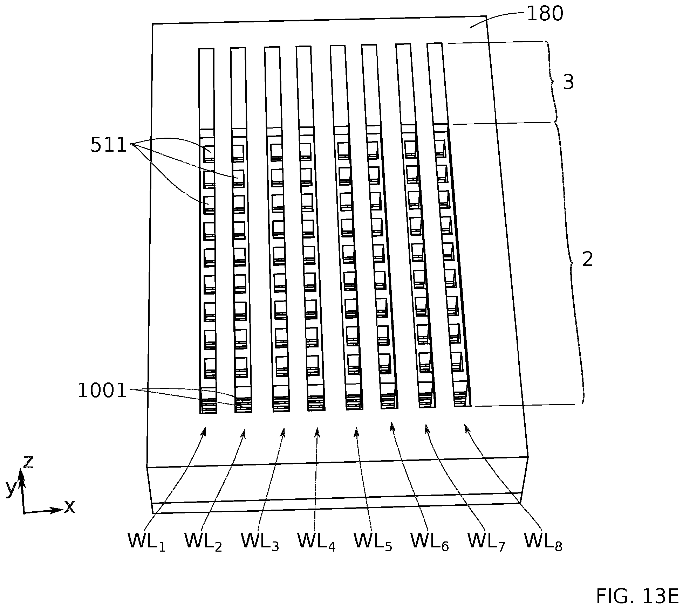

La figure 13E illustre la gravure sélective des portions 1003 de SiGe. Cette gravure présente une bonne sélectivité S_{SiGe:Si} par rapport au Si, de préférence S_{SiGe:Si} > 5:1. Cela permet de graver le SiGe tout en préservant les nanofils Si et les parties des sources 1002 exposées au niveau du premier côté des portions périphériques 312. Cette gravure présente également une bonne sélectivité S_{SiGe:SiN} par rapport au SiN, de préférence S_{SiGe:SiN} > 5:1. Cela permet de graver le SiGe tout en préservant les espaceurs 170_{C} en SiN et les bouchons 1004. La gravure est ainsi confinée le long des WL, en étant stoppée latéralement par les espaceurs SiN 170_{C} et le premier côté des portions périphériques 312.

A l'issue de la gravure, les canaux 1001 des transistors en Si sont suspendus entre les ouvertures 511 d'une même wordline WLₓ (x = 1... 8) (figure 13E).

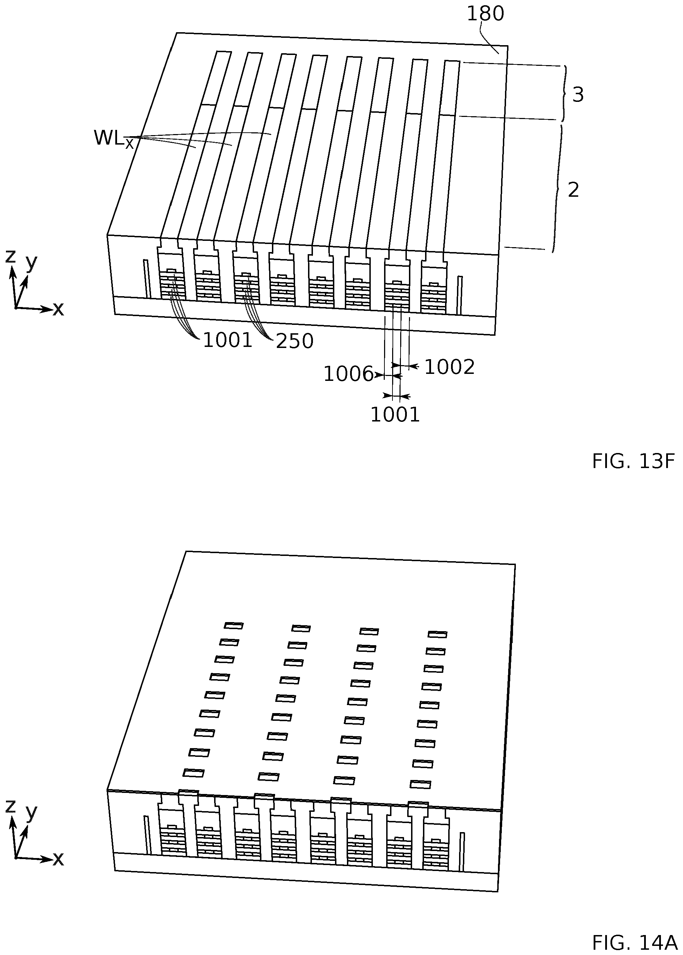

La figure 13F illustre la formation des grilles fonctionnelles à la place des grilles sacrificielles. Des dépôts successifs de matériaux utilisés pour la formation de grilles fonctionnelles permettent de former les grilles fonctionnelles 250 autour de chaque canal 1001. Ces grilles fonctionnelles peuvent être formées à partir d'un dépôt de matériau à haute constante diélectrique dit high-k, par exemple HfO2 sur une épaisseur de 2nm, suivi d'un dépôt de TiN sur une épaisseur de 3nm, suivi d'un dépôt de tungstène W visant à remplir les ouvertures 511 et les wordlines WLₓ délimitées par l'oxyde TEOS 180. Une planarisation par CMP avec arrêt sur l'oxyde TEOS 180 permet au besoin d'enlever les couches métalliques excédentaires. Les wordlines WLₓ (x = 1...8) sont ainsi définies. Les transistors de la matrice 3D sont donc des transistors MOS à grille enrobante (Gate-All-Around) à base de nanofils Si empilés.

La figure 13F permet de distinguer en coupe les sources 1002 des transistors, les canaux 1001 entourés par les grilles enrobantes 250, et des parties de nanofil formant les drains 1006 des transistors. Les sources 1002 s'étendent selon Y jusque dans la zone sourceline 3. Les drains 1006 s'étendent selon X jusqu'aux zones d'ouvertures 301 remplies d'oxyde 180.

### Structuration de la zone bitlines

L'étape suivante consiste à enlever l'oxyde 180 des zones d'ouvertures 301, de façon à accéder aux drains 1006 des transistors.

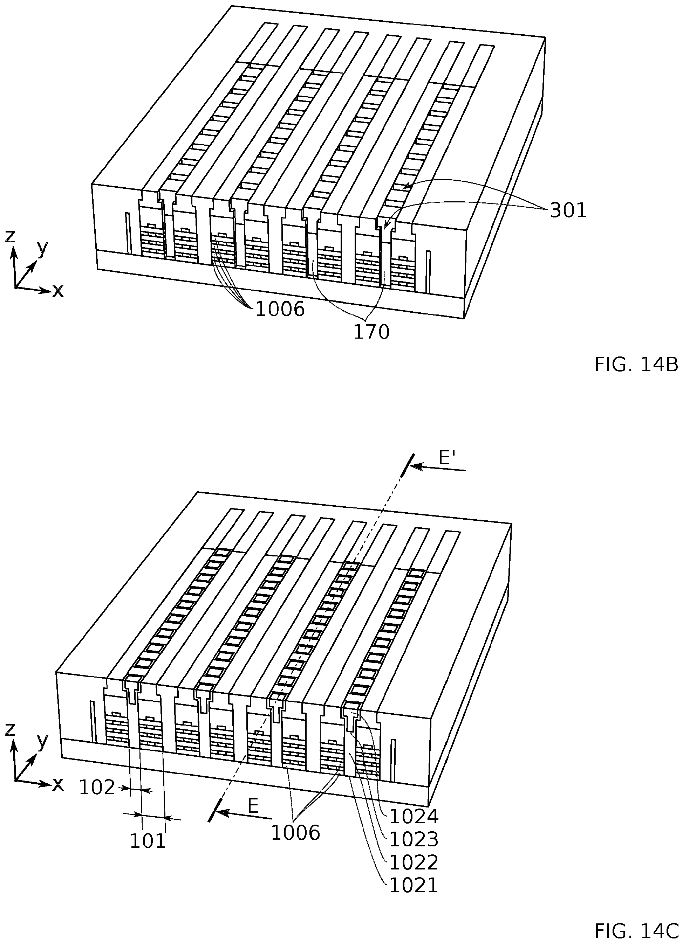

La figure 14A illustre une étape de lithographie préalable à la gravure de l'oxyde 180 au niveau des zones d'ouvertures 301. Avantageusement, les contraintes d'alignement liées à cette étape de lithographie sont diminuées grâce à la présence des espaceurs 170 noyés dans l'oxyde 180. Une gravure sélective de l'oxyde 180 vis-à-vis du nitrure SiN des espaceurs 170 permet dès lors d'exposer « automatiquement » les ouvertures 301 débouchant sur les drains 1006, tel qu'illustré à la figure 14B. La formation ultérieure des éléments résistifs des points mémoire précisément au niveau des ouvertures 301 est ainsi avantageusement assistée par la présence des espaceurs 170 définissant les ouvertures 301. Cette étape de lithographie/gravure de l'oxyde 180 destinée à ouvrir les zones de points mémoire est dite « auto-alignée », du fait de la présence des espaceurs 170 guidant la gravure de l'oxyde 180.

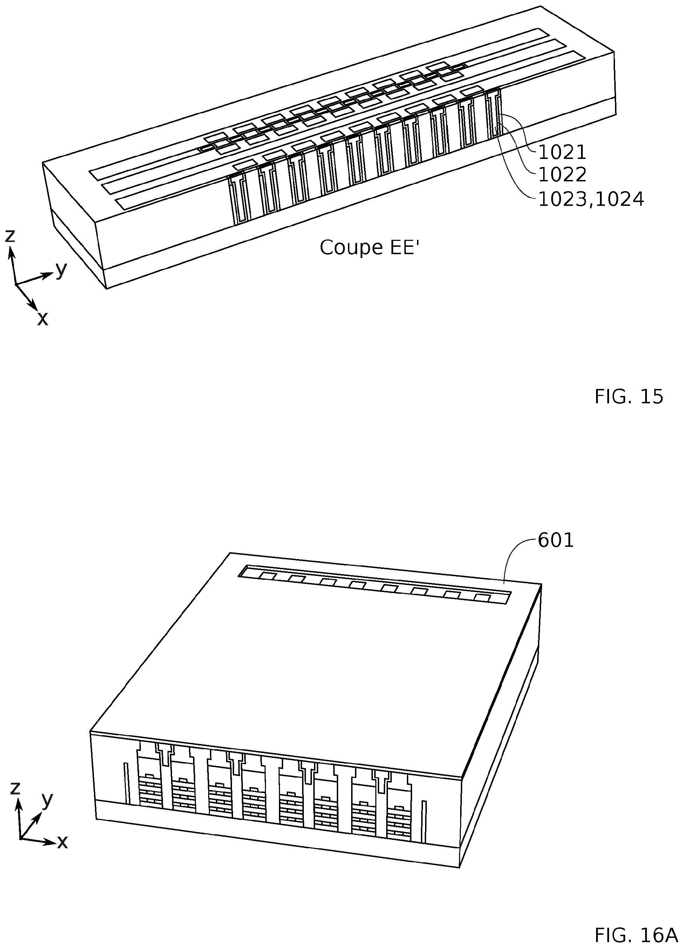

Après gravure de l'oxyde 180, les ouvertures 301 sont remplies par dépôts successifs de façon à former les points mémoire ou éléments mémoire 102, tel qu'illustré aux figures 14C et 15, respectivement selon une coupe transverse et une coupe longitudinale. Dans le cas d'une mémoire résistive de type OxRAM, ces éléments mémoire 102 peuvent être à base de HfO2. Par exemple, ces éléments mémoire 102 peuvent être réalisés par dépôt d'une couche HfO2 1021, par exemple d'épaisseur 5nm, suivi d'un dépôt d'une couche de Ti 1022, par exemple d'épaisseur 5nm, suivi d'un dépôt d'une couche de TiN 1023, par exemple d'épaisseur supérieure à 5nm suivi d'un dépôt d'une couche de W 1024, par exemple d'épaisseur 300nm. La couche de W 1024 peut typiquement s'étendre en dehors des ouvertures 301. Elle est alors planarisée par CMP avec arrêt sur la couche d'oxyde 180.

Les éléments mémoire 102 ainsi formés sont directement au contact des drains 1006 des transistors de sélection. Selon une possibilité, les drains 1006 peuvent être préalablement siliciurés avant le dépôt des couches formant les éléments mémoire 102. L'auto-alignement des points mémoires avec les drains 1006 des transistors de sélection permet notamment de rapprocher ces deux éléments formant une cellule mémoire résistive. Cela permet d'augmenter la densité de cellules mémoire résistives au sein de la matrice 3D.

En particulier, chaque élément mémoire 102 présente un bord ou flanc au contact d'un bord ou flanc d'un espaceur 170_{C} surmontant l'empilement formant les drains des transistors. Ces bords ou flancs s'étendent principalement selon des plans parallèles au plan yz.

### Formation des contacts

La figure 16A illustre une étape de lithographie visant à former des contacts dans la zone sourceline 3 de la matrice 3D. Les contacts à former dans la zone sourceline 3 sont de préférence des contacts en escalier. Une séquence d'étapes de lithographie/gravure permet alors, de façon connue, de former de tels contacts en escalier, sur chacun des niveaux de source. Typiquement, une première ligne 601 de motifs de contacts est définie par lithographie (figure 16A).

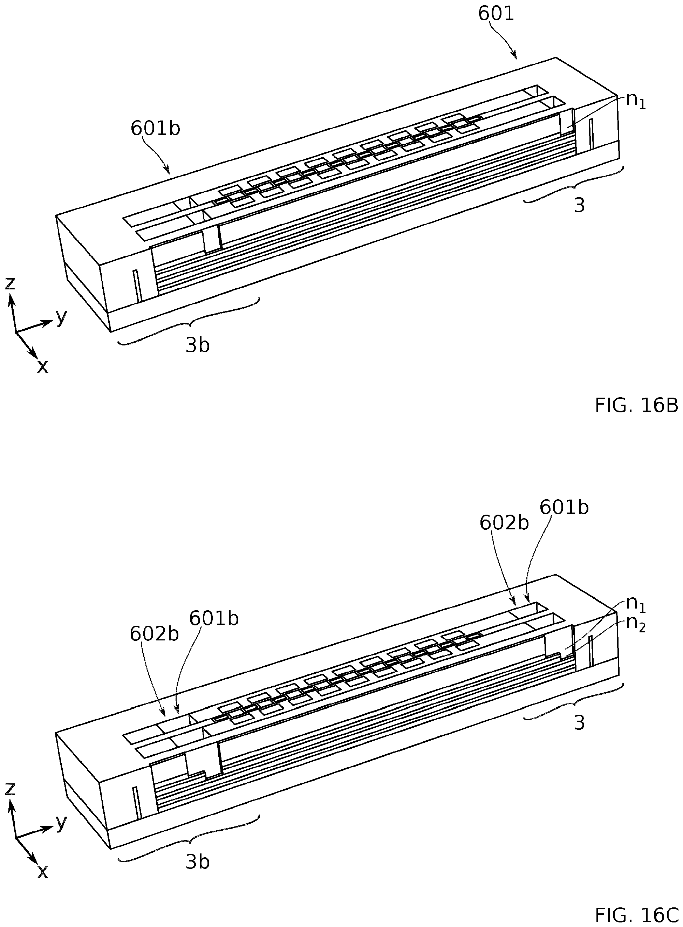

Une première gravure configurée pour atteindre et graver le premier niveau n1 de source est alors effectuée (figure 16B).

Une deuxième lithographie peut ensuite permettre de définir une deuxième ligne 602 de motifs de contacts, tout en gardant la première ligne 601 exposée. Une deuxième gravure similaire à la première gravure est effectuée. Cela permet d'atteindre et graver simultanément le premier niveau n1 de source au niveau de la deuxième ligne 602 et le deuxième niveau n2 de source au niveau de la première ligne 601 (figure 16C).

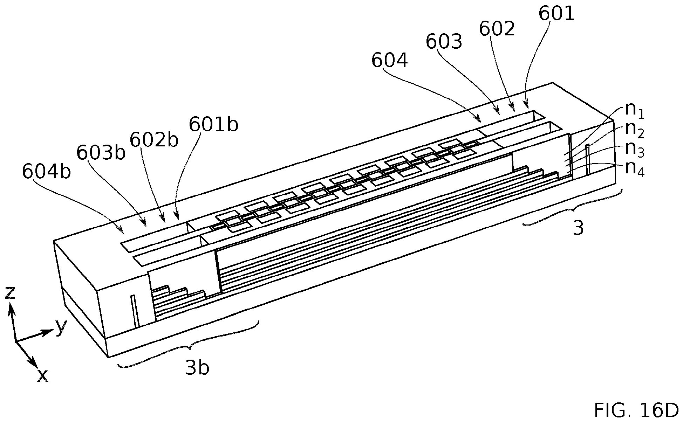

Une troisième lithographie peut ensuite permettre de définir une troisième ligne 603 de motifs de contacts, tout en gardant les première et deuxième lignes 601, 602 exposées. Une troisième gravure similaire aux première et deuxième gravures est effectuée. Cela permet d'atteindre et graver simultanément le premier niveau n1 de source au niveau de la troisième ligne 603, le deuxième niveau n2 de source au niveau de la deuxième ligne 602 et le troisième niveau n3 de source au niveau de la première ligne 601 (figure 16D).

Dans l'exemple illustré ici comprenant 4 niveaux de sources n1, n2, n3, n4, une quatrième et dernière lithographie/gravure permet d'atteindre et d'exposer le premier niveau n1 de source au niveau d'une quatrième ligne 604 (figure 16D).

Les 4 niveaux de sources n1, n2, n3, n4 sont ainsi respectivement exposés en escalier au niveau des lignes 604, 603, 602, 601. Cela permet de former ensuite des contacts en escalier permettant de connecter indépendamment les différents niveaux de sources.

Les niveaux de sources n1, n2, n3, n4 peuvent être exposés via les lignes 604, 603, 602, 601 dans la zone sourceline 3, et éventuellement via des lignes 604b, 603b, 602b, 601b dans une autre zone sourceline 3b tel qu'illustré sur les figures 16B à 16D.

Selon une possibilité, la réduction de cote de la résine utilisée lors de la lithographie/gravure, classiquement appelée « trimming », peut avantageusement être mise à profit pour réduire le nombre d'étapes de lithographie.

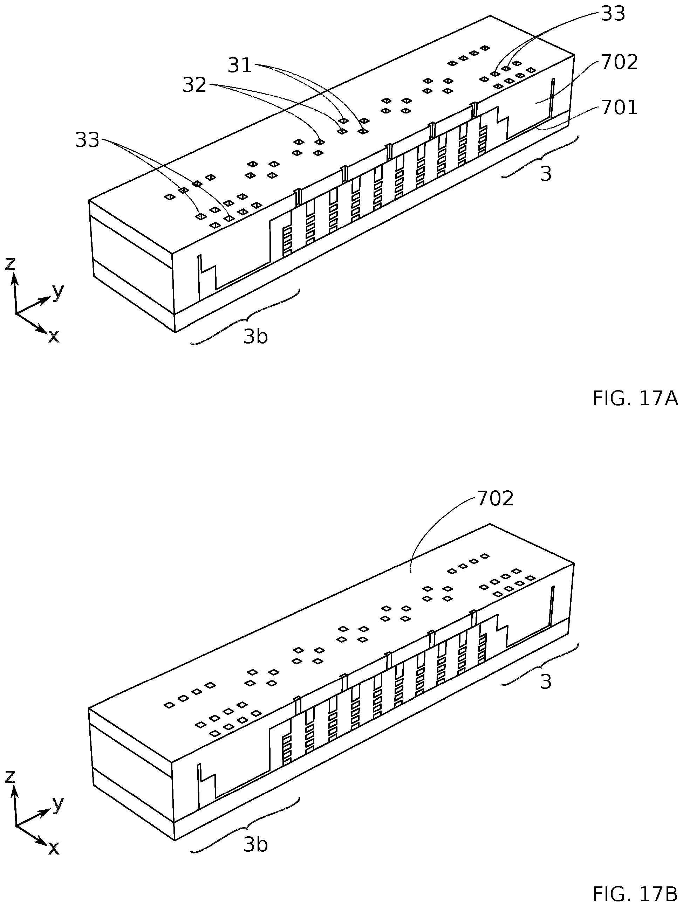

Après avoir gravé les différentes couches de Si/SiN pour accéder aux niveaux de sources, une couche de nitrure 701 d'épaisseur comprise entre 5nm et 20nm, par exemple environ 10nm est déposée dans les zones sourceline 3, 3b. Une couche d'oxyde 702 SiO2 épaisse est ensuite déposée sur l'ensemble de la structure et planarisée par CMP, tel qu'illustré à la figure 17A.

Les trous de contacts 31, 32, 33 sont ensuite formés par lithographie/gravure au travers de la couche d'oxyde 702 (figure 17A). Les trous de contact 31 sont dédiés à la connexion des wordlines avec les grilles des transistors de sélection. Les trous de contact 32 sont dédiés à la connexion des bitlines avec les points mémoire. Les trous de contact 33 sont dédiés à la connexion des sourcelines avec les sources des transistors de sélection.

La couche de nitrure 701 sert de couche d'arrêt pour la gravure des trous de contacts 33 dans les zones sourceline 3, 3b. Les couches de tungstène des grilles fonctionnelles et des points mémoire servent de couche d'arrêt pour la gravure des trous de contacts 31, 32. La couche de nitrure 701 est ensuite gravée au niveau des trous de contacts 33 pour exposer le silicium des sources.

Les contacts sont alors formés en remplissant les trous de contact 31, 32, 33 par dépôts successifs de TiN d'épaisseur environ 7nm et de tungstène W d'épaisseur environ 200 nm. Une planarisation par CMP avec arrêt sur la couche d'oxyde 702 permet d'obtenir une matrice 3D de cellules mémoire intégrable, telle qu'illustrée à la figure 17B.

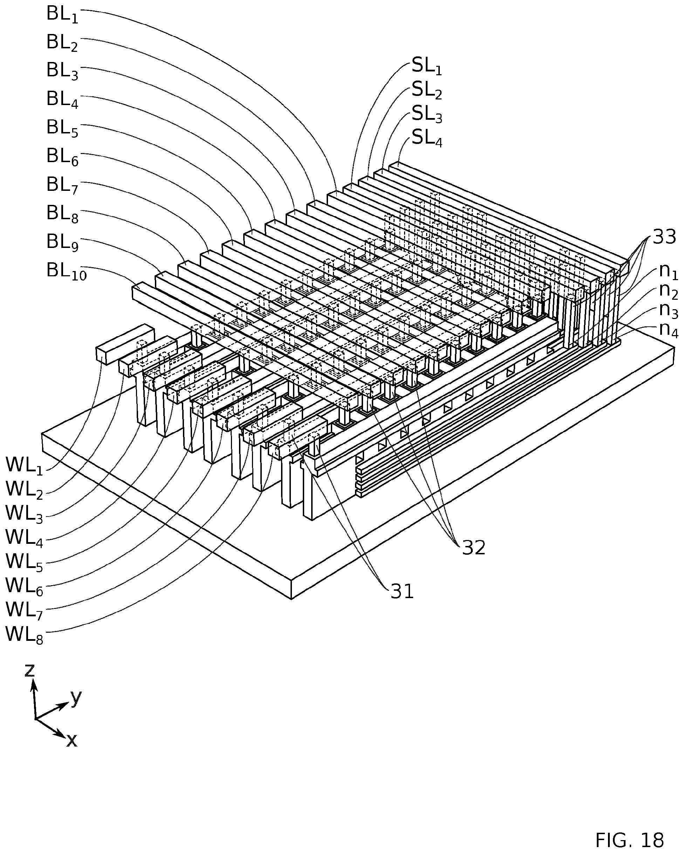

La figure 18 montre une telle matrice 3D de cellules mémoire sans la couche 702, pour plus de clarté. Les lignes de contact sourceline SL1, SL2, SL3, SL4, wordlines WL_{1,} WL₂, WL₃, WL₄, WL₅, WL₆, WL₇, WL₈ et bitline BL₁, BL₂, BL₃, BL₄, BL₅, BL₆, BL₇, BL₈, BL₉, BL₁₀ sont également visibles en transparence sur cette figure 18. Les contacts 31, 33 illustrés ici correspondent à une autre possibilité d'intégration de la matrice 3D, légèrement différente de celle illustrée par les figures 17A, 17B. De façon évidente, ces contacts peuvent être définis selon différents plans organisationnels, en fonction des contraintes d'intégration.

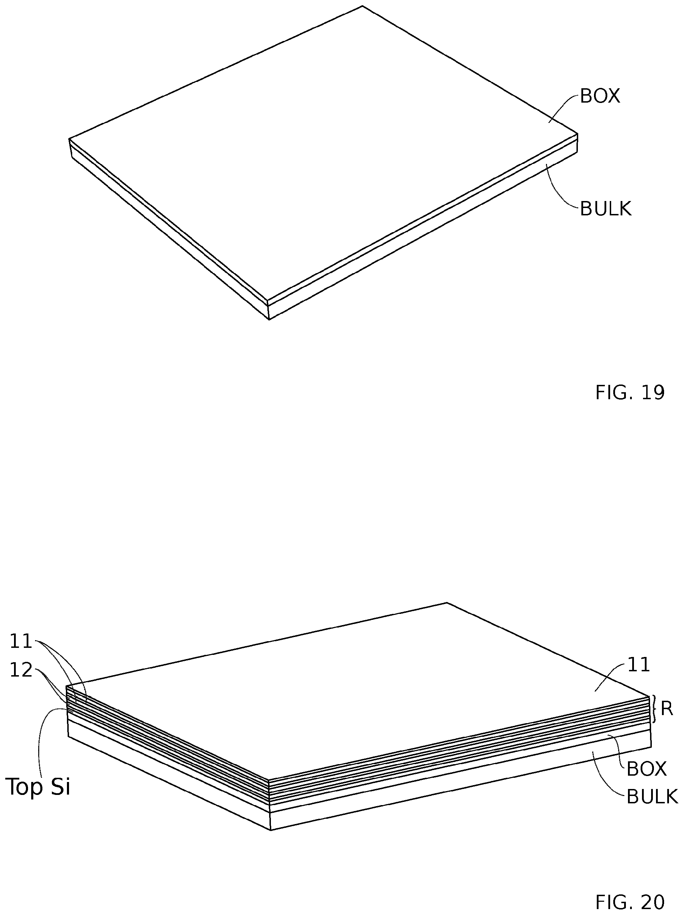

Un deuxième exemple de réalisation d'une mémoire résistive de type OxRAM va maintenant être décrit en référence aux figures 19 à 57 dans la section suivante. Seules les caractéristiques distinctes du premier exemple de réalisation sont décrites en détail ci-après, les autres caractéristiques non décrites ou partiellement décrites étant réputées sensiblement identiques à celles du premier exemple de réalisation.

### Exemple 2

Dans cet exemple, certaines étapes de fabrication sont interverties par rapport à l'enchaînement d'étapes du premier exemple de réalisation. Cela permet de diminuer le nombre d'étapes total. Cela permet également de simplifier la réalisation technique de certaines parties de la mémoire 3D.

Comme précédemment, sur un substrat SOI comprenant un support en silicium noté BULK, une couche mince d'oxyde SiO2 notée BOX, et une couche mince de Si notée topSi, des couches minces en SiGe 11 et en Si 12 sont alternativement formées par épitaxie.

La figure 19 illustre uniquement le BULK et le BOX du substrat SOI.

La figure 20 illustre le super réseau Si/SiGe noté R comprenant le topSi et les couches SiGe11 et Si 12 alternées.

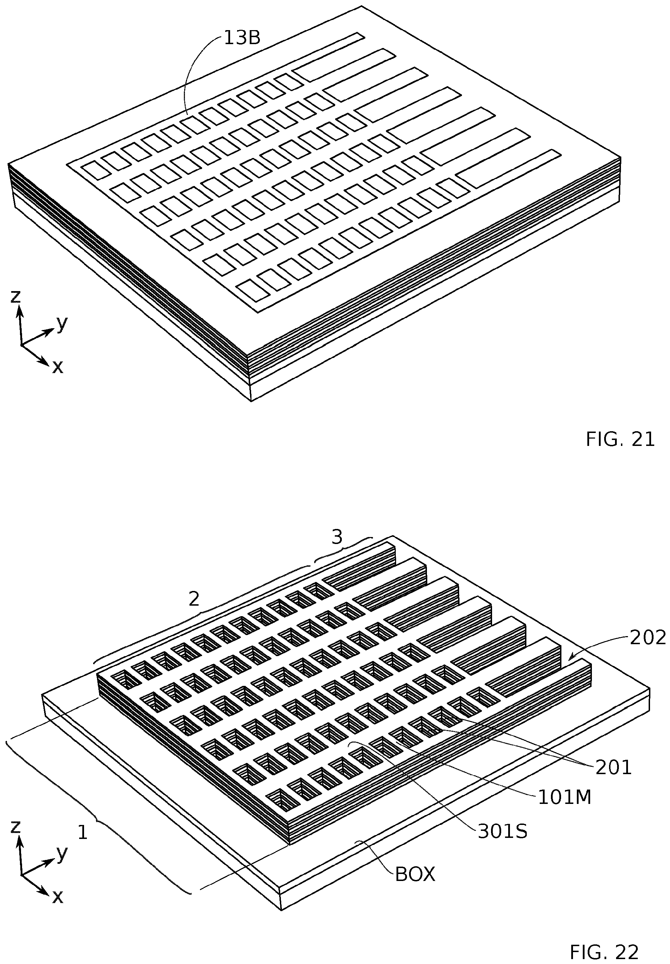

La figure 21 illustre une étape de lithographie visant à définir les différentes zones sourcelines, wordlines, bitlines par un premier masque 13B.

La figure 22 illustre la gravure anisotrope selon Z de l'empilement E avec arrêt sur le BOX. Elle peut être effectuée comme précédemment par plasma en utilisant une chimie de gravure HBr/O2. Elle permet de définir les motifs de transistors 101M, les motifs de sources 301S et les ouvertures 201, 202. Les ouvertures 202 dans la zone sourcelines 3 sont significativement plus larges que les ouvertures 201 de la matrice définie par les zones wordlines 1 et bitlines 2. Cela permet de réserver des emplacements suffisamment larges pour la formation des contacts de sourcelines, en particulier pour les contacts sourcelines en escalier.

### Formation des contacts

Dans cet exemple, la formation des contacts en escalier est effectuée préalablement aux autres étapes.

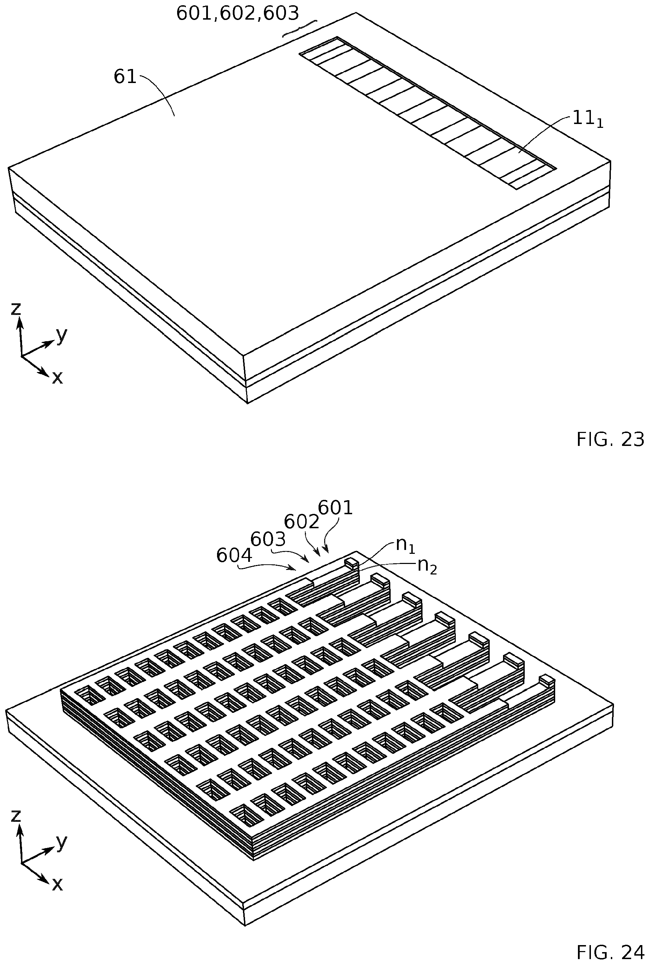

La figure 23 illustre une étape de lithographie visant à former des contacts dans la zone sourceline 3 de la matrice 3D. Les contacts à former dans la zone sourceline 3 sont de préférence des contacts en escalier. Une séquence d'étapes de lithographie/gravure permet alors, de façon connue, de former de tels contacts en escalier, sur chacun des niveaux de source. Typiquement, un dépôt de résine 61 est d'abord effectué de manière à couvrir l'ensemble des zones sourceline 3, wordlines 1 et bitlines 2 structurées précédemment. Cela permet de protéger les zones en dehors de la zone d'intérêt pour la formation des contacts en escalier. Une première ouverture dans la zone sourceline 3 permettant d'exposer la couche SiGe 11₁ relative au niveau n1, au niveau des lignes 601, 602, 603 de motifs de contacts, est définie par lithographie (figure 23).

Une première gravure configurée pour atteindre et graver le premier niveau n1 de Si est alors effectuée (figure 24).

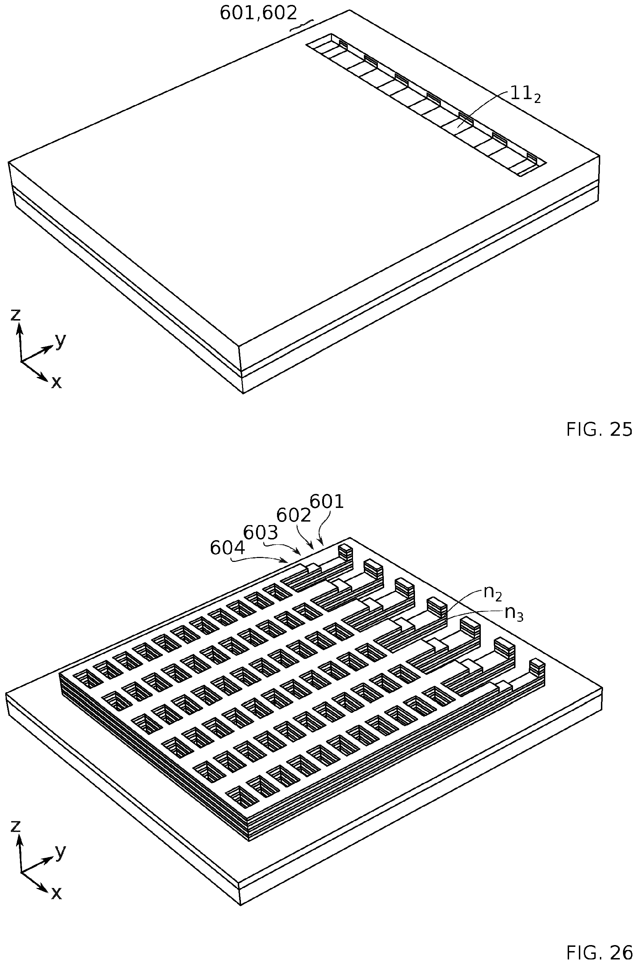

Une deuxième lithographie (figue 25) peut ensuite définir une deuxième ouverture permettant d'exposer la couche SiGe 11₂ relative au niveau n2, au niveau des lignes 601, 602, de motifs de contacts. Une deuxième gravure similaire à la première gravure est effectuée. Cela permet d'atteindre et graver le deuxième niveau n2 de Si au niveau des lignes 601, 602 (figure 26).

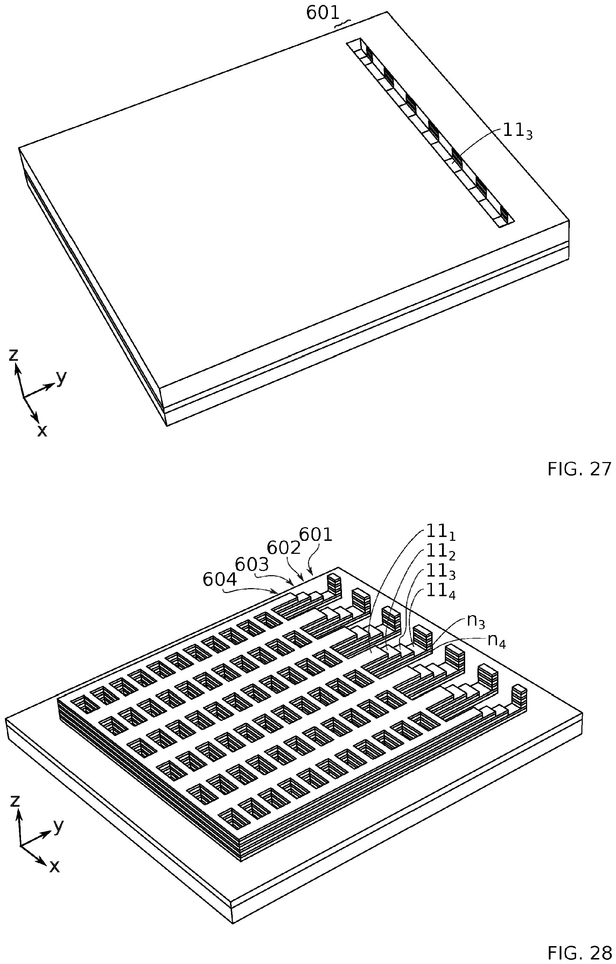

Une troisième lithographie (figue 27) peut ensuite définir une troisième ouverture permettant d'exposer la couche SiGe 11₃ relative au niveau n3, au niveau de la ligne 601, de motifs de contacts. Une troisième gravure similaire aux première et deuxième gravures est effectuée. Cela permet d'atteindre et graver le troisième niveau n3 de Si au niveau de la ligne 601 (figure 28).

Dans l'exemple illustré ici comprenant 4 niveaux de Si n1, n2, n3, n4, les couches SiGe 11₁, 11₂, 11₃, 11₄ sont exposées en escalier respectivement au niveau des lignes 604, 603, 602, 601 de la zone sourcelines 3 (figure 28). Une étape de lithographie/gravure est avantageusement supprimée dans ce deuxième exemple de réalisation, par rapport au premier exemple de réalisation.

La résine 61 n'est pas nécessairement entièrement retirée et/ou redéposée entre chaque lithographie/gravure.

### Formation des grilles sacrificielles

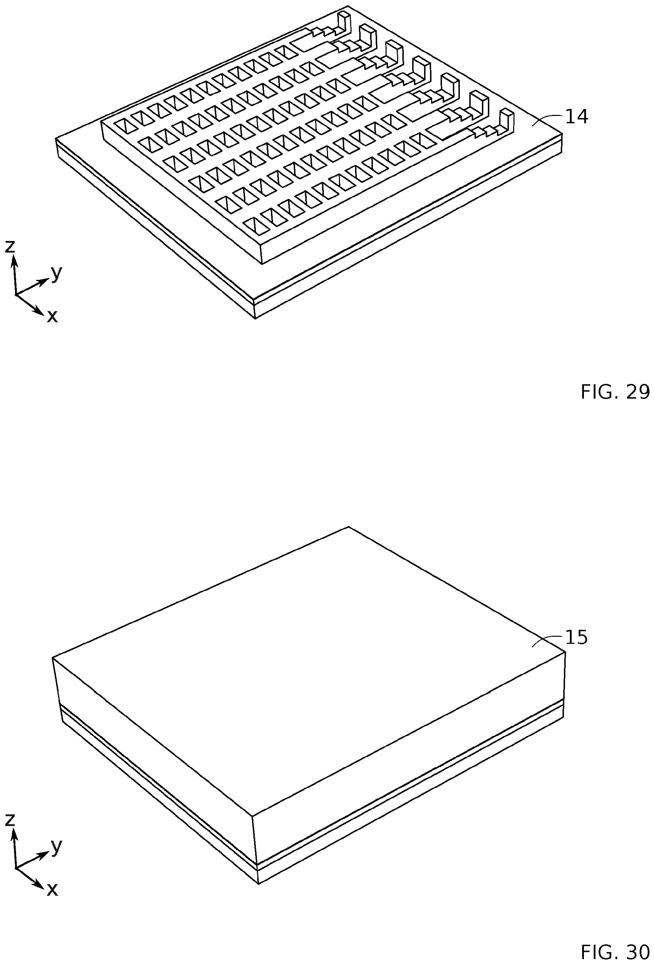

Les figures 29 à 33 illustrent des étapes de formation des grilles sacrificielles.

Les figures 29 et 30 illustrent respectivement des étapes de dépôt d'une couche 14 d'oxyde de silicium SiO2 et d'une couche 15 de silicium polycristallin (polySi). L'épaisseur de SiO2 déposé peut typiquement être de quelques nanomètres, par exemple 7 nm. Le polySi est déposé de façon à remplir les ouvertures 201, 202. L'épaisseur de polySi déposé peut typiquement être de quelques centaines de nanomètres, par exemple 380 nm. Ces dépôts successifs forment un empilement SiO2/polySi s'apparentant à un empilement de grille classique. La structuration de cet empilement permet de former les grilles sacrificielles.

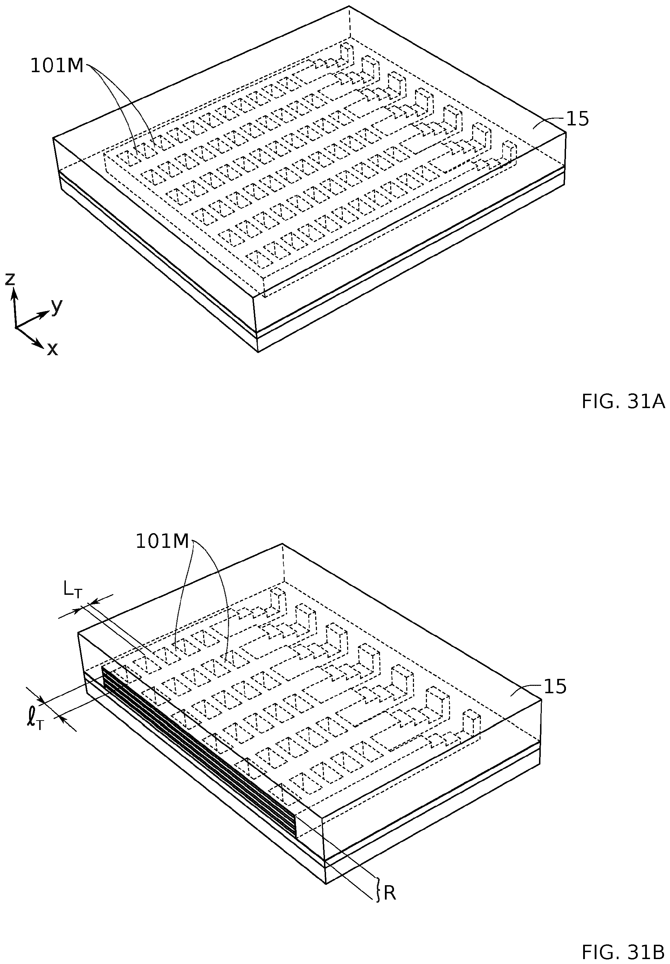

La figure 31A illustre une étape de planarisation du polySi 15, typiquement par polissage mécano-chimique CMP. Cette CMP peut être arrêtée au temps, par exemple au bout de quelques dizaines de secondes. Les motifs 101M, 301S des zones wordlines et bitlines, ainsi que les contacts structurés en escalier de la zone sourcelines sont visibles par transparence au travers de la couche polySi planarisée 15.

La figure 31B est une vue en coupe transverse selon XZ au travers des motifs 101M, de la structure obtenue à l'issue de l'étape illustrée à la figure 31A. Les motifs 101M de longueur I_{T} et de largeur LT, formés dans le super-réseau R, sont visibles sur cette figure 31B.

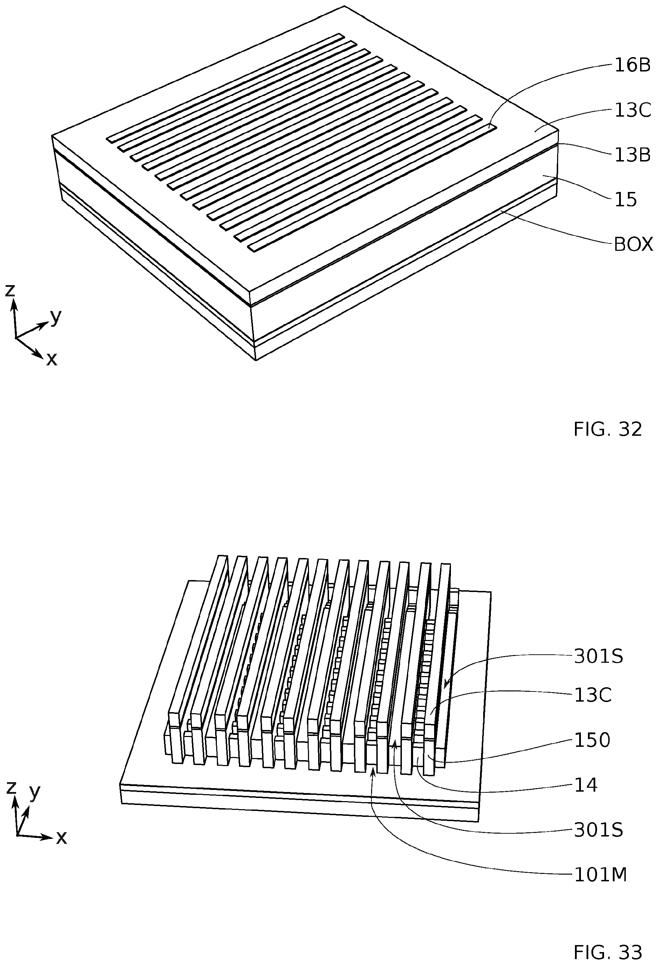

La figure 32 illustre une étape de lithographie visant à définir les grilles sacrificielles via un deuxième masque 16B.

Préalablement, une couche de nitrure 13B et une couche d'oxyde SiO2 13C sont successivement déposées sur la couche polySi 15 planarisée.

La figure 33 illustre la gravure anisotrope selon Z de l'oxyde 13C, du nitrure 13B et du polySi 15. La couche 14 de TEOS et l'oxyde enterré (BOX) servent avantageusement de couche d'arrêt lors de la gravure du Poly-Si. Les grilles sacrificielles 150 sont ainsi formées à cheval sur les portions périphériques des motifs de transistors 101M. Elles s'étendent principalement selon Y et bordent selon X les motifs de sources 301S, comme précédemment.

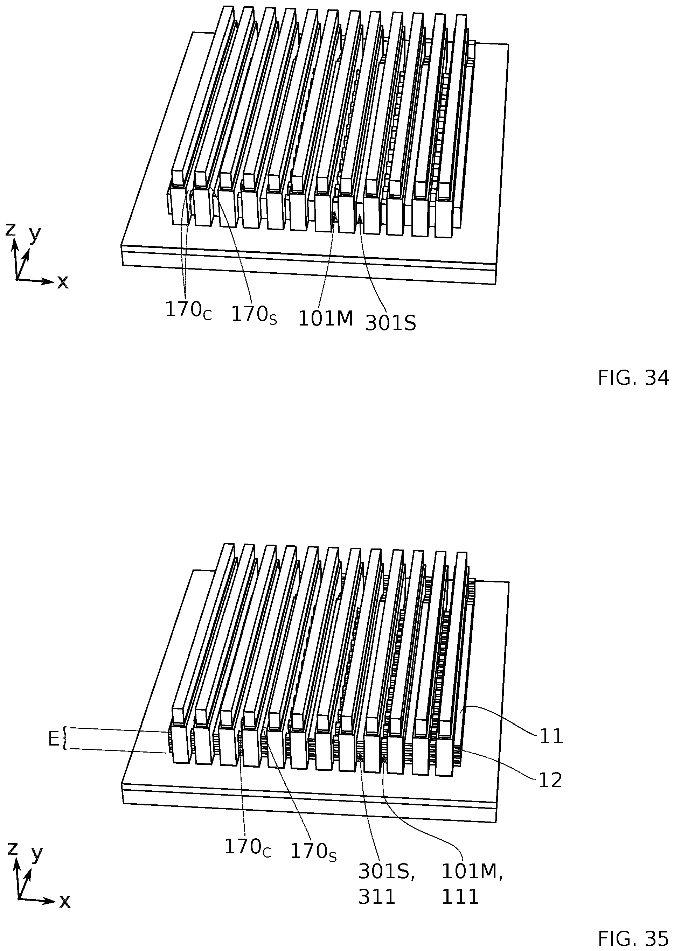

La figure 34 illustre la formation d'espaceurs 170_{C}, 170_{S} de part et d'autres des grilles sacrificielles 150. Ces espaceurs sont typiquement formés à partir d'un dépôt d'une couche de SiN conforme suivi d'une gravure anisotrope de cette couche de SiN, comme précédemment. Les motifs de sources 301S sont ainsi en partie couverts par les espaceurs 170_{S}. Les motifs de transistors 101M sont ainsi en partie couverts par les espaceurs 170_{C}.

La figure 35 illustre le retrait des parties exposées de la couche 14 d'oxyde TEOS, après formation des espaceurs 170_{C}, 170_{S}. Ce retrait permet d'exposer une portion centrale 111 des motifs de transistors 101M, entre les espaceurs 170_{C}, et une portion centrale 311 des motifs de sources 301S entre les espaceurs 170_{S}.

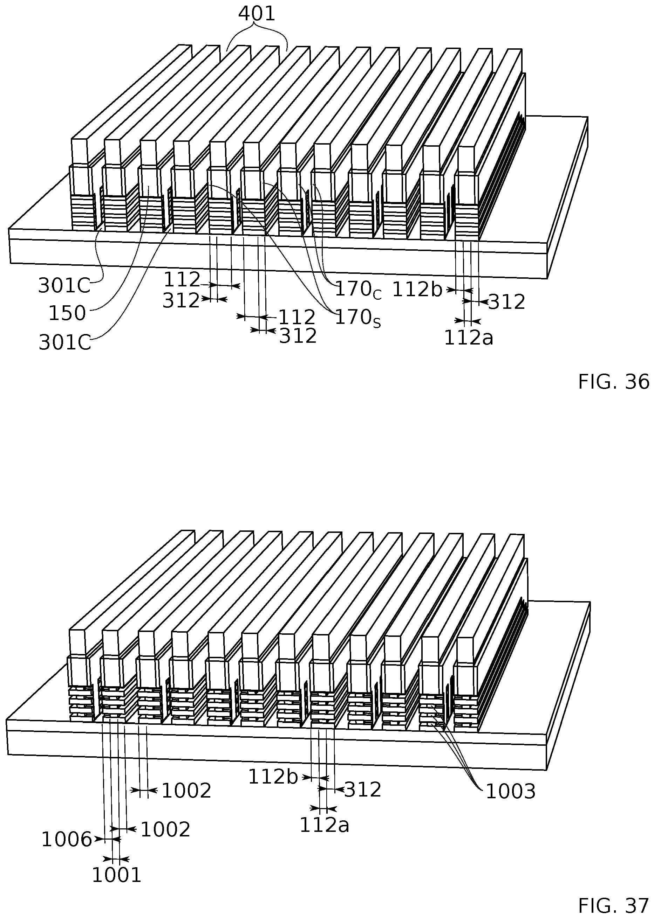

Les portions centrales 111 et 311 sont ensuite gravées de façon anisotrope selon Z, jusqu'au BOX, comme illustré à la figure 36. Cela permet de structurer l'empilement Si/SiGe sous forme de peigne.

Des portions périphériques 312 des motifs de sources 301S sont conservées à l'issue de cette gravure, sous les espaceurs 170_{S}. Ces portions périphériques 312 sont continues le long de l'axe Y. Elles forment le corps du peigne. Un premier côté de ces portions périphériques 312 débouche sur les ouvertures 401. Un deuxième côté de ces portions périphériques 312 est attaché aux grilles sacrificielles 150. Préférentiellement, les couches Si de ces portions périphériques 312 formeront ultérieurement les sources des transistors.

Des portions périphériques 112 des motifs de transistors 101M sont également conservées à l'issue de cette gravure, sous les grilles sacrificielles 150 et les espaceurs 170_{C}. Ces portions périphériques 112 s'étendent selon X et débouchent sur les ouvertures 301c. Les portions périphériques 112 forment les dents du peigne. Elles sont reliées entre elles par les portions périphériques 312. Préférentiellement, les couches Si de ces portions périphériques 112 formeront ultérieurement les canaux et les drains des transistors.

### Isolation des sources

Comme précédemment, afin de pouvoir adresser indépendamment chacun des transistors de la matrice 3D, il est nécessaire d'isoler entre elles les couches de Si des différents niveaux n1, n2, n3, n4. Les couches SiGe sont donc de préférence retirées et remplacées par des couches électriquement isolantes.

Comme illustré à la figure 37, les sources 1002 des transistors correspondent aux couches Si des portions périphériques 312 des motifs de sources 301S. Pour isoler ces sources 1002 entre elles, des portions des couches SiGe de l'empilement sont gravées à partir des ouvertures 401, 301c, comme précédemment.

La gravure est configurée de manière à ce que les couches SiGe des portions périphériques 312 soient gravées au travers des ouvertures 401. L'arrêt du front de gravure peut être contrôlé au temps, de préférence sensiblement à l'aplomb des grilles sacrificielles 150. Les sources 1002 sont dès lors suspendues.

La gravure des couches SiGe s'effectue de préférence également au travers des ouvertures 301c. La gravure sélective des couches SiGe se fait ainsi de part et d'autre de l'empilement, au niveau des motifs de transistors, tel qu'illustré à la figure 37. Des parties 1006 des couches Si des portions périphériques 112b des motifs de transistors 101M sont dès lors suspendues. Ces parties 1006 se présentent sous forme de fils et correspondent sensiblement aux drains des transistors.

La gravure est de préférence arrêtée avant que les couches SiGe soient totalement retirées. Des portions 1003 de SiGe sont ainsi conservées entre les couches Si des portions périphériques 112a des motifs de transistors 101M. Cela permet à la fois de définir les canaux 1001 et/ou les drains 1006 en Si, et d'éviter un risque d'effondrement des couches Si. Ces portions 1003 sont par la suite retirées de façon à former les grilles enrobantes des transistors GAA.

Les grilles sacrificielles en Poly-Si permettent notamment de maintenir les couches Si lors de la gravure SiGe. Elles forment une structure de piliers d'accroché pour les couches Si.

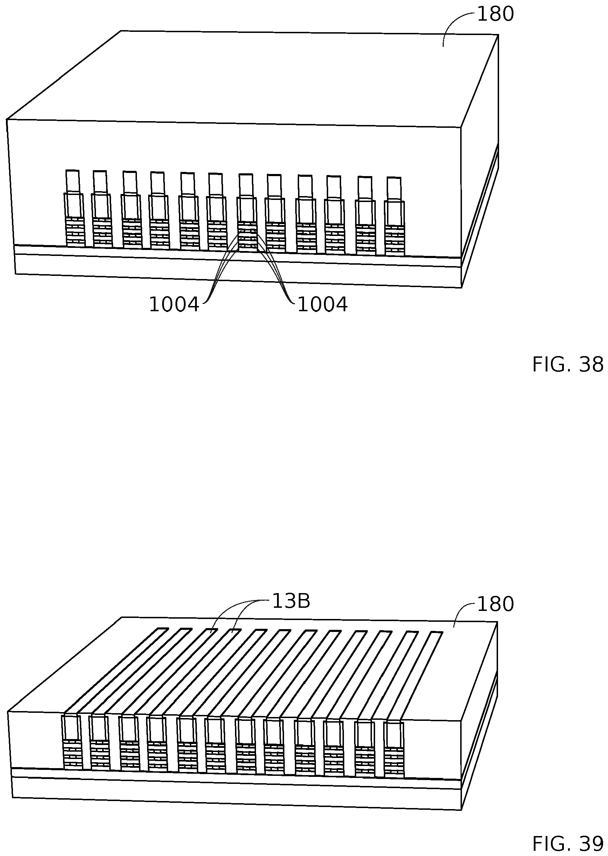

La figure 38 illustre la formation de bouchons 1004 diélectriques, par exemple en SiN, au niveau des cavités formées par le retrait du SiGe, comme précédemment. Les sources 1002 sont ainsi isolées électriquement entre elles. Les drains 1006 sont également isolés électriquement entre eux.

Une couche d'oxyde 180 est ensuite déposée de façon à remplir les ouvertures 401, 301c (figure 38). Cette couche d'oxyde 180 est ensuite planarisée par CMP avec arrêt sur les parties 13B de masque dur en SiN, comme illustré à la figure 39.

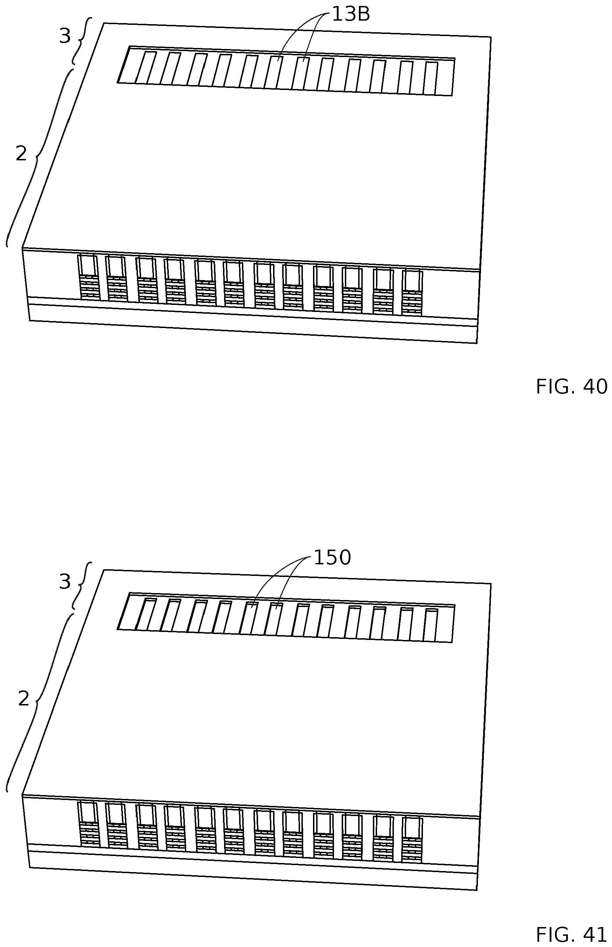

Une étape de lithographie est effectuée de façon à protéger la zone bitlines 2 et à exposer la zone sourcelines 3 (figure 40). Le masque dur 13B est retiré dans cette zone sourcelines 3, de façon à exposer les grilles sacrificielles 150 au niveau de la zone sourcelines 3 (figure 41).

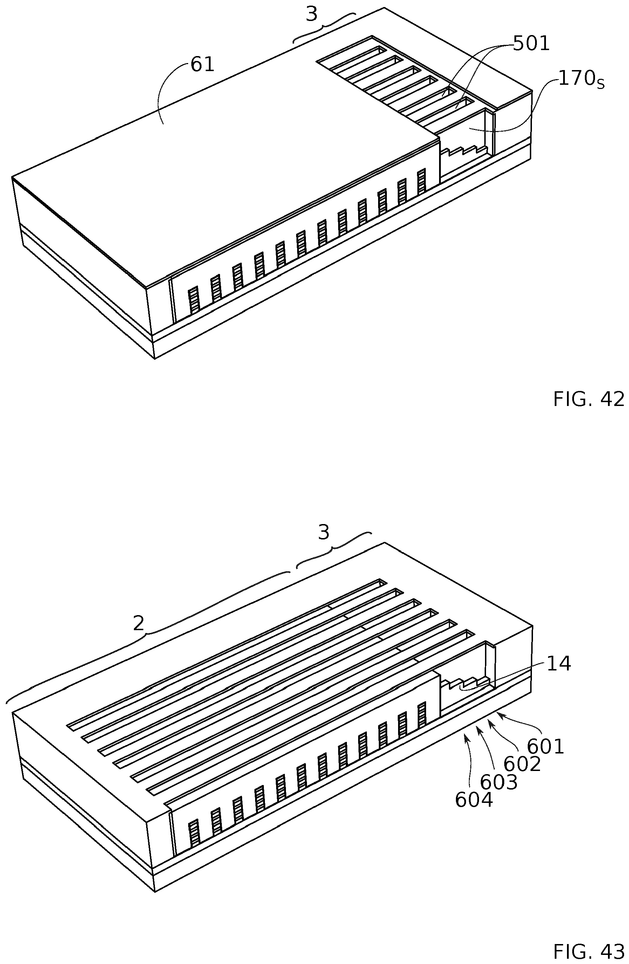

Les grilles sacrificielles 150 de la zone sourceline 3 sont ensuite retirées, tel qu'illustré à la figure 42. Le polySi des grilles sacrificielles peut être gravé à l'aide d'une solution TMAH ou TEAH, ou par gravure plasma anisotrope, par exemple à base de chimies CH₂F₂/SF₆/N₂/He et HBr/O2/He. Dans l'exemple illustré à la figure 42, le retrait des grilles sacrificielles 150 forme des ouvertures 501. Ces ouvertures 501 débouchent sur les contacts en escalier reliés aux sources 1002 (non visibles). Les ouvertures 501 sont bordées par les espaceurs 170_{C}, 170_{S}.

La résine 61 est ensuite retirée de façon à exposer la zone bitlines 2Le nitrure du masque dur 13B dans la zone bitlines 2 et des espaceurs 170_{C}, 170_{S} dans la zone sourceline 3 est ensuite gravé, comme illustré à la figure 43. Cela permet de dégager les sources 1002 structurées en escalier et recouvertes de l'oxyde 14 dans la zone sourcelines 2. Les lignes 604, 603, 602, 601 de motifs de contacts, correspondant chacune à une marche des contacts en escalier, sont également représentées à la figure 43.

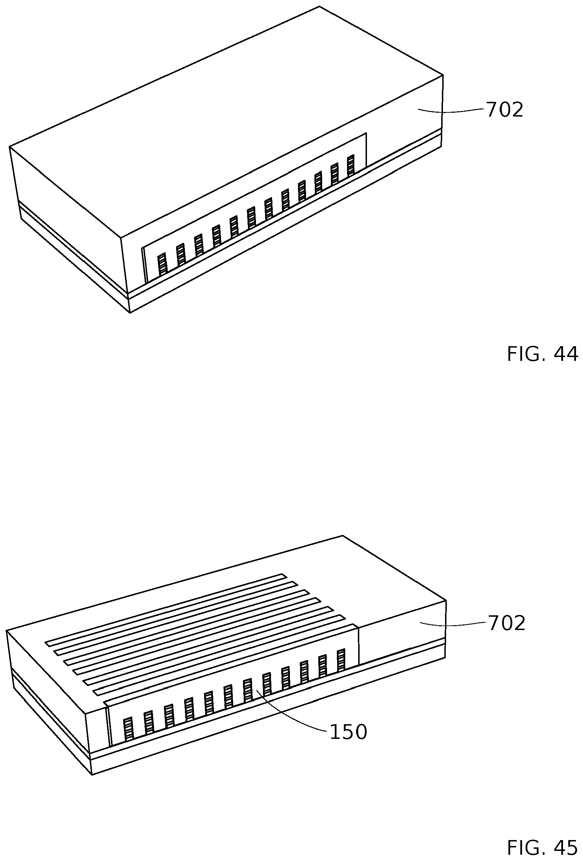

Une couche d'oxyde 702 SiO2 épaisse est ensuite déposée sur l'ensemble de la structure (figure 44) et planarisée par CMP avec arrêt sur les sommets des grilles sacrificielles 150 (figure 45).

### Structuration de la zone wordlines

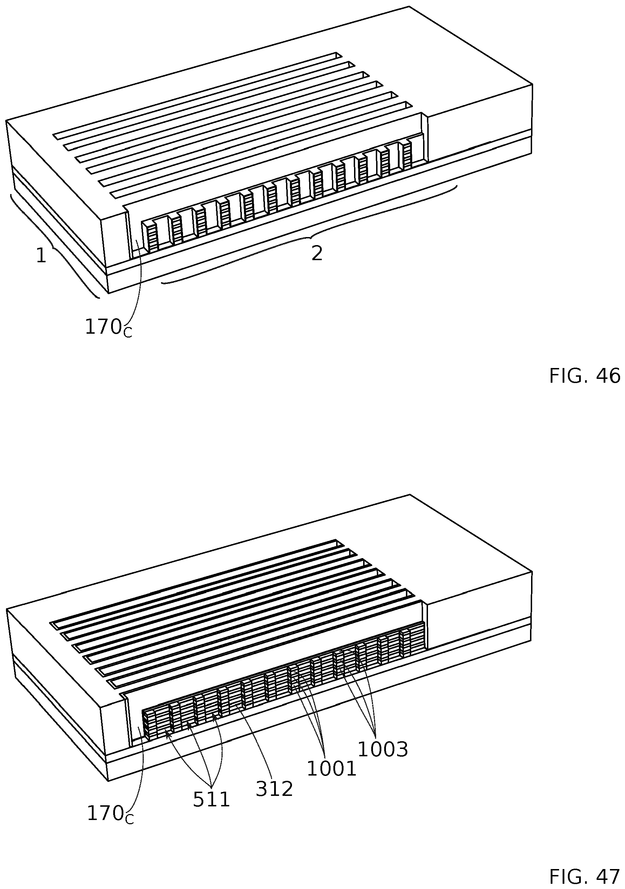

Les figures 46 et 47 illustrent le retrait des grilles sacrificielles 150 de la zone wordlines 1, comme précédemment. Le polySi (figure 46) puis le TEOS (figure 47) sont successivement retirés.

Dans l'exemple illustré à la figure 47, le retrait des grilles sacrificielles 150 forme des ouvertures 511. Ces ouvertures 511 sont bordées selon XZ par des empilements formés par les canaux Si 1001 et les portions SiGe 1003. Ces ouvertures 511 sont bordées selon YZ par les portions périphériques 312 comprenant l'empilement des sources 1002 isolées entre elles, et par les espaceurs 170_{C} (non visible) en regard desdites portions périphériques 312.

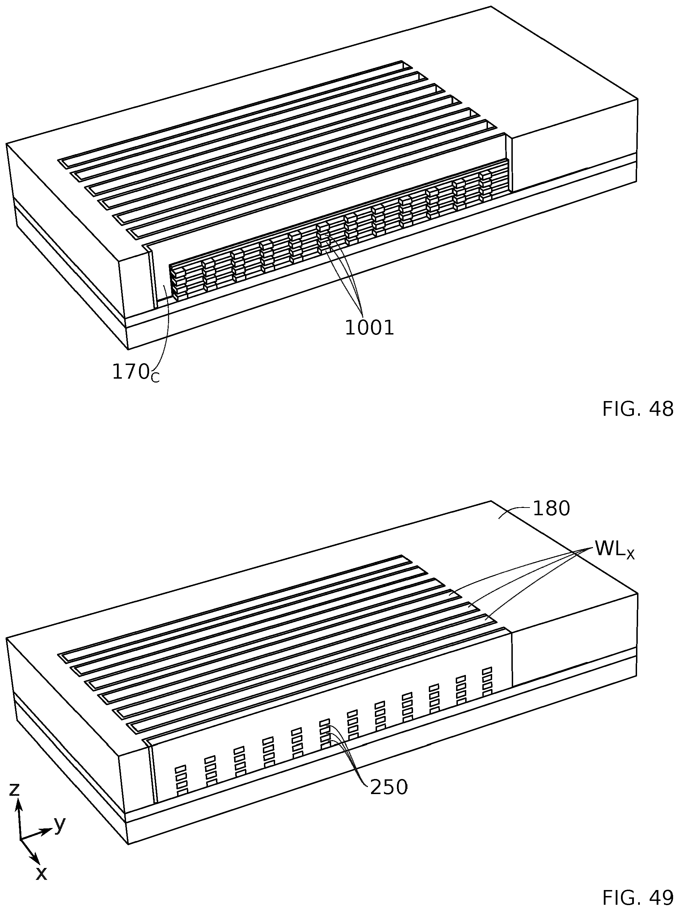

La figure 48 illustre la gravure sélective des portions 1003 de SiGe, comme précédemment. Cette gravure permet de graver le SiGe tout en préservant les canaux 1001 sous forme de nanofils Si et les parties des sources 1002 exposées au niveau des portions périphériques 312. A l'issue de la gravure, les canaux 1001 des transistors en Si sont suspendus entre les ouvertures 511 d'une même wordline WLₓ.

La figure 49 illustre la formation des grilles fonctionnelles à la place des grilles sacrificielles. Des dépôts successifs de matériaux utilisés pour la formation de grilles fonctionnelles permettent de former les grilles fonctionnelles 250 autour de chaque canal 1001, comme précédemment. Ces grilles fonctionnelles peuvent être formées à partir d'un dépôt de matériau à haute constante diélectrique dit high-k, par exemple HfO2 sur une épaisseur de 2nm, suivi d'un dépôt de TiN sur une épaisseur de 3nm, suivi d'un dépôt de tungstène W visant à remplir les ouvertures 511 et les wordlines WLₓ délimitées par l'oxyde TEOS 180. Une planarisation par CMP avec arrêt sur l'oxyde TEOS 180 permet au besoin d'enlever les couches métalliques excédentaires. Les wordlines WLₓ sont ainsi définies. Les transistors de la matrice 3D sont des transistors MOS à grille enrobante (Gate-All-Around) à base de nanofils Si empilés.

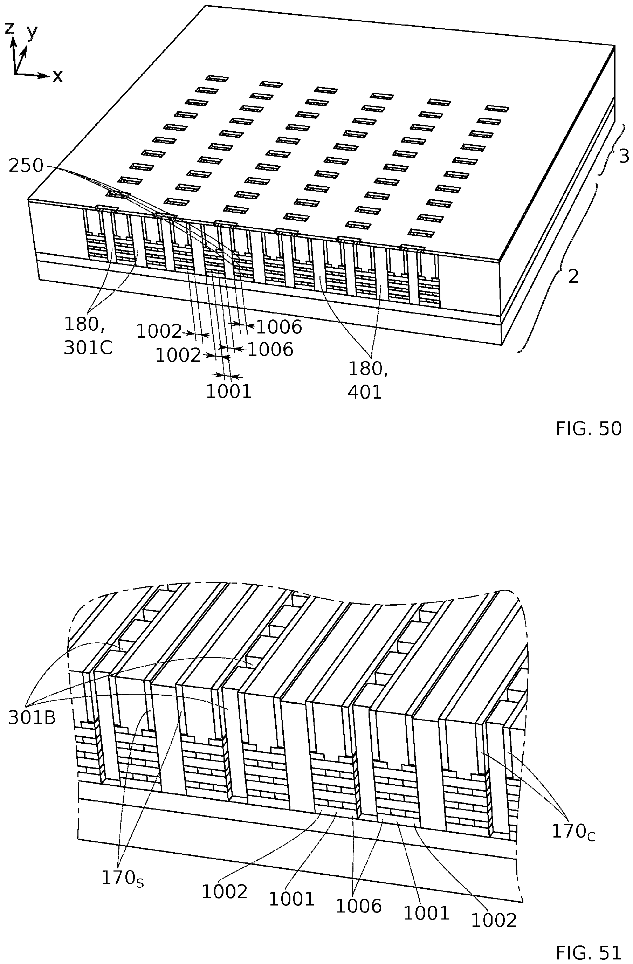

La figure 50 permet de distinguer en coupe selon XZ les sources 1002 des transistors, les canaux 1001 entourés par les grilles enrobantes 250, et des parties de nanofil formant les drains 1006 des transistors. Les sources 1002 s'étendent selon Y jusque dans la zone sourceline 3. Les drains 1006 s'étendent selon X jusqu'aux zones d'ouvertures 301c remplies d'oxyde 180.

### Structuration de la zone bitlines

L'étape suivante consiste à enlever en partie l'oxyde 180 des zones d'ouvertures 301c, de façon à accéder aux drains 1006 des transistors dans la zone bitlines 2.

La figure 50 illustre une étape de lithographie préalable à la gravure de l'oxyde 180 au niveau des zones d'ouvertures 301c. La gravure sélective de l'oxyde 180 permet de former des ouvertures 301B exposant une extrémité des drains 1006 en Si, tel qu'illustré à la figure 51.

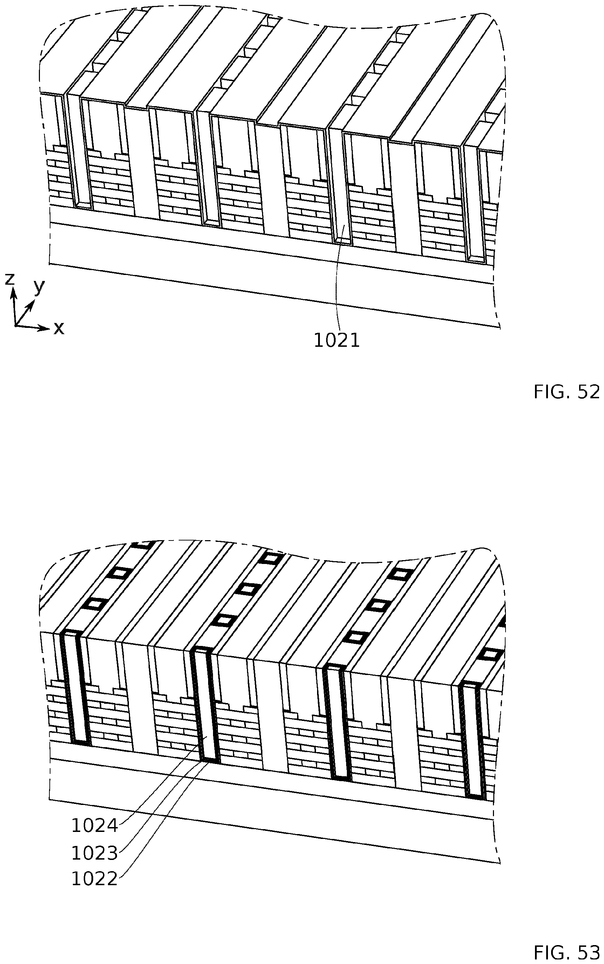

Ces ouvertures 301B sont remplies par dépôts successifs de façon à former les points mémoire, tel qu'illustré aux figures 52 et 53. Les points mémoire ainsi formés sont directement au contact des drains 1006 des transistors de sélection. Les drains 1006 peuvent être préalablement siliciurés. Dans le cas d'une mémoire résistive de type OxRAM, ces points mémoire peuvent être à base de HfO2. Par exemple, ces points mémoire peuvent être réalisés par dépôt d'une couche HfO2 1021 d'épaisseur 5nm, suivi d'un dépôt d'une couche de Ti 1022 d'épaisseur 5nm, suivi d'un dépôt d'une couche de TiN 1023 d'épaisseur supérieure à 5nm suivi d'un dépôt d'une couche de W 1024 d'épaisseur 300nm. La couche de W 1024 peut typiquement s'étendre en dehors des ouvertures 301c. Elle est alors planarisée par CMP avec arrêt sur la couche d'oxyde 180.

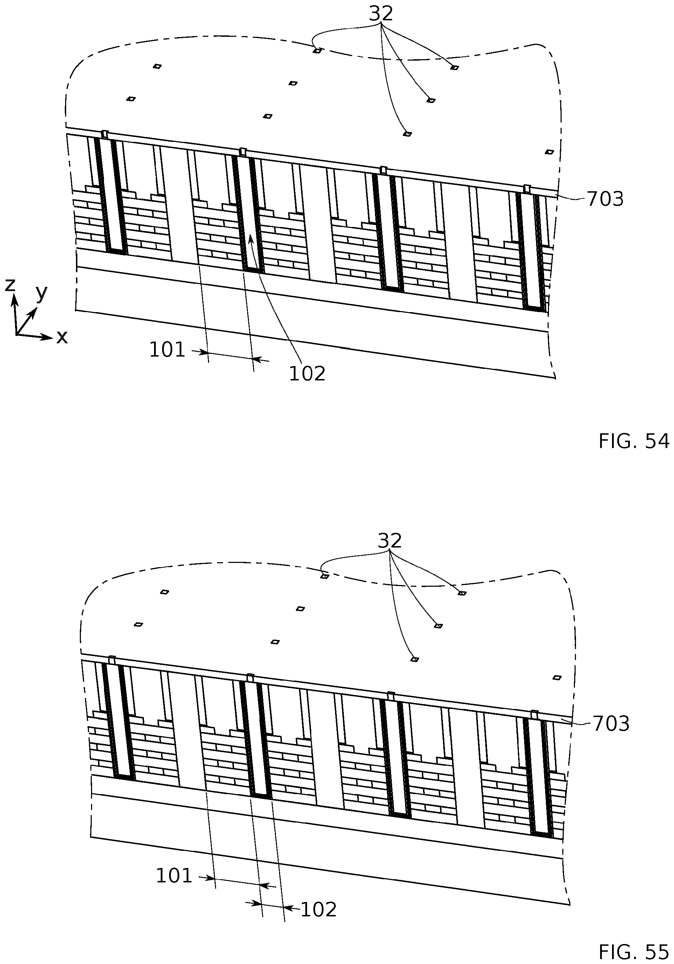

Une couche d'oxyde 703 est de préférence déposée sur la matrice 3D ainsi formée. Les trous de contacts 32 sont ensuite formés par lithographie/gravure au travers de la couche d'oxyde 703, tel qu'illustré aux figures 54 et 55. Les trous de contact 32 sont dédiés à la connexion des bitlines avec les points mémoire. Les trous de contact dédiés à la connexion des wordlines avec les grilles des transistors de sélection et les trous de contact 33 dédiés à la connexion des sourcelines avec les sources des transistors de sélection sont également formés par lithographie/gravure au travers des couche d'oxyde 703, 702.

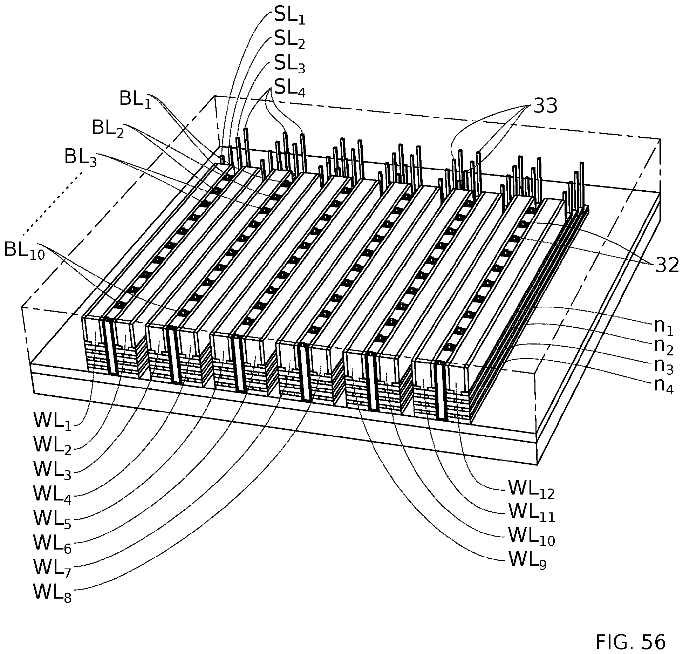

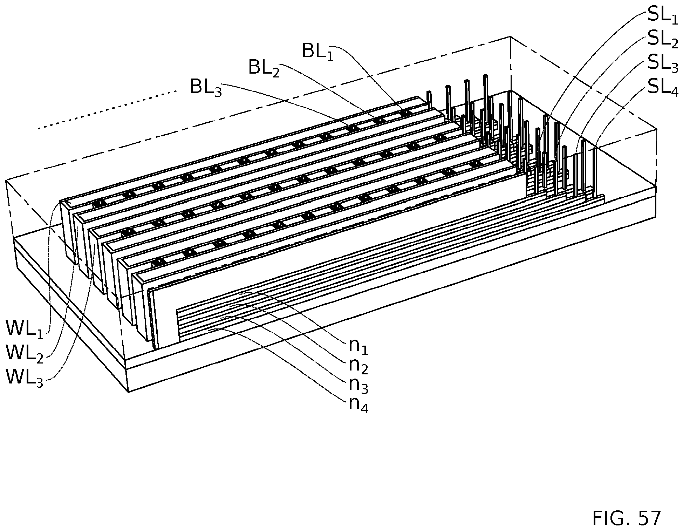

Les figures 56 et 57 présentent une mémoire résistive 3D obtenue par ce deuxième mode de réalisation, respectivement selon une coupe transverse selon XZ et selon une coupe longitudinale selon YZ.

Les lignes de contact sourceline SL1, SL2, SL3, SL4 connectant indépendamment chacun des niveaux n1, n2, n3, n4 de la matrice, les wordlines WL1, WL2, WL3, WL4, WL5, WL6, WL7, WL8, WL9, WL10, WL11, WL12 et les bitline BL1, BL2, BL3, BL4, BL5, BL6, BL7, BL8, BL9, BL10 sont visibles en transparence sur ces figures 56 et 57. Les contacts 32, 33 sont également illustrés sur ces figures 56 et 57.

De façon générale, l'invention n'est pas limitée aux modes de réalisation décrits mais s'étend à tout mode de réalisation entrant dans la portée de la revendication 1. L'invention permet avantageusement de former une architecture 3D de mémoire résistive comprenant une densité de cellules mémoire améliorée.

Le projet à l'origine de cette demande a reçu un financement du Conseil européen de la recherche (CER) dans le cadre du programme de recherche et d'innovation Horizon 2020 de l'Union européenne (convention de subvention n° 820048).

## Revendications

1. Dispositif microélectronique comprenant au moins deux cellules mémoire (10_{x, y, z}) comprenant chacune un transistor (101) dit de sélection et un élément mémoire (102) associé audit transistor de sélection, chaque transistor (101) comprenant un canal (1001) sous forme de fil s'étendant principalement selon une première direction (x), une grille (250) bordant ledit canal (1001) et s'étendant principalement selon une deuxième direction (y), une première région correspondant à l'un parmi une source (1002) ou un drain (1006), et une deuxième région correspondant à l'autre parmi la source (1002) ou le drain (1006), la deuxième région étant connectée à l'élément mémoire (102), lesdits transistors (101) étant empilés principalement selon une troisième direction (z) et occupant chacun un niveau (n1, n2, n3, n4) d'altitude donnée selon la troisième direction (z), le dispositif microélectronique étant **caractérisé en ce que** les première et deuxième régions sont entièrement couvertes par des espaceurs (170_{S}, 170_{C}) en projection selon la troisième direction (z) dans un plan (xy).

2. Dispositif selon la revendication précédente dans lequel au moins l'un des transistors (101) de sélection, et de préférence une pluralité des transistors de sélection, présente une grille (250) dite enrobante, entourant totalement le canal (1001) dudit transistor de sélection.

3. Dispositif selon l'une quelconque des revendications précédentes dans lequel l'élément mémoire (102) présente une résistivité variable, de façon à former des cellules mémoires (10_{x, y, z}) résistives, par exemple de type OxRAM.

4. Dispositif selon l'une quelconque des revendications précédentes dans lequel les grilles (250) des transistors sont connectées électriquement entre elles et les premières régions (1002) des transistors sont isolées électriquement entre elles.

5. Dispositif selon l'une quelconque des revendications précédentes dans lequel les premières régions (1002) des transistors s'étendent principalement selon la deuxième direction (y) normale à la première direction (x).

6. Système microélectronique comprenant une pluralité de dispositifs microélectroniques selon l'une quelconque des revendications précédentes connectés entre eux, les transistors (101) de deux dispositifs microélectroniques adjacents présentant une première région (1002) commune pour un même niveau (n_{z}) et étant associés à deux éléments mémoire (102) distincts, de façon à former une matrice 3D de cellules mémoires.

7. Système selon la revendication précédente dans lequel les grilles (250) des transistors sont connectées électriquement entre elles dans une zone de lignes de mots (1), et dans lequel les premières régions (1002) des transistors de deux niveaux (n_{z}) différents sont isolées électriquement entre elles.

8. Système selon la revendication précédente dans lequel les premières régions, de préférence les sources (1002), occupant différents niveaux (n_{z}) sont connectées en escalier à des contacts (33), indépendamment les unes des autres, dans une zone de lignes de source (3).

9. Procédé de fabrication d'un dispositif microélectronique comprenant au moins deux cellules mémoire (10_{x, y, z}) comprenant chacune un transistor (101) dit de sélection et un élément mémoire (102) associé audit transistor de sélection, chaque transistor (101) comprenant un canal (1001) sous forme de fil s'étendant principalement selon une première direction (x), une grille (250) bordant ledit canal et s'étendant principalement selon une deuxième direction (y), une première région correspondant à l'un parmi une source (1002) ou un drain (1006) et une deuxième région correspondant à l'autre parmi la source ou le drain connectée à l'élément mémoire (102), lesdits transistors (101) étant empilés principalement selon une troisième direction (z) et occupant chacun un niveau (n1, n2, n3, n4) d'altitude donnée selon la troisième direction (z), le procédé comprenant les étapes suivantes :
- Former un empilement selon la troisième direction (z), de couches alternées d'un premier matériau semiconducteur et d'un deuxième matériau diélectrique,
- Former à partir de cet empilement des ouvertures (201, 202, 301, 301_{c}, 401) définissant des motifs de transistors (101M) comprenant chacun une partie centrale (112a) s'étendant principalement selon la première direction (x) et des première et deuxième parties périphériques (312, 112b), s'étendant de part et d'autre de la partie centrale (112a), ladite partie centrale (112a) étant destinée à former le canal (1001) du transistor (101) et lesdites première et deuxième parties périphériques (312, 112b) étant destinées à former respectivement les première et deuxième régions du transistor (1002, 1006),
- Former des motifs de grilles (150) en partie dans les ouvertures (201, 202), à cheval sur les parties centrales (112a) des motifs de transistors (101M) et s'étendant principalement selon une deuxième direction (y) en bordure des premières parties périphériques (312),
- Former des espaceurs longitudinaux (170_{S}, 170_{C}) de part et d'autre des motifs de grilles (150), lesdits espaceurs longitudinaux (170_{S}, 170_{C}) couvrant entièrement les première et deuxième parties périphériques (312, 112b) des motifs de transistors (101M) en projection selon la troisième direction (z) dans un plan (xy),
- Former les éléments mémoire (102) de sorte que chaque élément mémoire (102) présente un bord en alignement selon la troisième direction (z) avec un bord d'un espaceur longitudinal (170_{C}),
- Former les grilles (250) des transistors à partir des motifs de grille (150).

10. Procédé selon la revendication précédente dans lequel la formation de l'empilement comprend les étapes suivantes :
- Former par épitaxie un empilement (E) provisoire selon la troisième direction (z) comprenant au moins deux couches (12) semi-conductrices du premier matériau semiconducteur séparées par au moins une couche sacrificielle (11) en un deuxième matériau semi-conducteur,
- Après formation des motifs de grilles (150), retirer l'au moins une couche sacrificielle (11) à partir desdites ouvertures (201, 301, 401),
- Remplir par le deuxième matériau diélectrique un espace laissé par le retrait de l'au moins une couche sacrificielle (11), de façon à former au moins une couche diélectrique.

11. Procédé selon la revendication précédente dans lequel le premier matériau semi-conducteur est du silicium et le deuxième matériau semi-conducteur est un alliage de silicium-germanium.

12. Procédé selon l'une quelconque des trois revendications précédentes dans lequel la formation des grilles (250) comprend les étapes suivantes :
- Retirer les motifs de grille (150), également dénommés grilles sacrificielles, de façon à dégager entièrement les canaux (1001) formés dans les parties centrales (112a) des motifs de transistors 101M),
- Déposer un matériau diélectrique de grille puis un matériau métallique de grille autour desdits canaux (1001) de façon à former des grilles (250) dites enrobantes entourant totalement au moins un canal (1001) parmi lesdits canaux.

13. Procédé selon la revendication précédente en combinaison avec l'une quelconque des deux revendications 10 et 11 dans lequel l'au moins une couche diélectrique comprend des portions (1003) restantes de l'au moins une couche sacrificielle (11) au niveau des parties centrales (112a) des motifs de transistors (101M) entre les canaux (1001) des transistors et dans lequel ces portions (1003) restantes sont retirées après le retrait des motifs de grille (150) et avant formation des grilles (250).

14. Procédé selon l'une quelconque des revendications 9 à 13 comprenant en outre des gravures en escalier dans une zone de lignes de source (3), de façon à atteindre les premières régions (1002) des différents niveaux (n1, n2, n3, n4), et la formation de contacts (33) en escalier sur les premières régions (1002) des différents niveaux (n1, n2, n3, n4).

15. Procédé selon l'une quelconque des revendications 9 à 14 dans lequel la formation des éléments mémoire (102) au niveau des deuxièmes régions (1006) est guidée par des espaceurs transverses (170) s'étendant principalement dans un plan normal à la direction d'extension principale des espaceurs longitudinaux (170_{C}).

## Patentansprüche

1. Mikroelektronikvorrichtung, umfassend mindestens zwei Speicherzellen (10_{x, y, z}), von denen jede einen Transistor (101) der Auswahl und ein Speicherelement (102) umfasst, das mit dem Auswahltransistor assoziiert ist, wobei jeder Transistor (101) einen Kanal (1001) in Drahtform, der sich hauptsächlich entlang einer ersten Richtung (x) erstreckt, ein Gitter (250), das an den Kanal (1001) angrenzt und sich hauptsächlich entlang einer zweiten Richtung (y) erstreckt, einen ersten Bereich, der einem von einer Source (1002) oder einem Drain (1006) entspricht, und einen zweiten Bereich, der dem anderen von der Source (1002) oder dem Drain (1006) entspricht, umfasst, wobei der zweite Bereich mit dem Speicherelement (102) verbunden ist, die Transistoren (101) hauptsächlich entlang einer dritten Richtung (z) gestapelt sind und jeweils ein gegebenes Höhenniveau (n1, n2, n3, n4) entlang der dritten Richtung (z) einnehmen, wobei die Mikroelektronikvorrichtung **dadurch gekennzeichnet ist, dass** die ersten und zweiten Bereiche vollständig von Abstandshaltern (170ₛ, 170_{c}) bedeckt sind, die entlang der dritten Richtung (z) in einer Ebene (xy) hervorstehen.

2. Vorrichtung nach dem vorstehenden Anspruch, wobei mindestens einer der Auswahltransistoren (101) und vorzugsweise eine Vielzahl von Auswahltransistoren ein einkapselndes Gitter (250) aufweist, das den Kanal (1001) des Auswahltransistors komplett umgibt.

3. Vorrichtung nach einem der vorstehenden Ansprüche, wobei das Speicherelement (102) einen variablen Widerstand derart aufweist, um resistive Speicherzellen (10_{x, y, z}) zu bilden, zum Beispiel vom OxRAM-Typ.

4. Vorrichtung nach einem der vorstehenden Ansprüche, wobei die Gitter (250) der Transistoren untereinander elektrisch verbunden sind und die ersten Bereiche (1002) der Transistoren untereinander elektrisch isoliert sind.

5. Vorrichtung nach einem der vorstehenden Ansprüche, wobei die ersten Bereiche (1002) der Transistoren sich hauptsächlich entlang der zweiten Richtung (y) senkrecht zu der ersten Richtung (x) erstrecken.

6. Mikroelektroniksystem, umfassend eine Vielzahl von untereinander verbundenen Mikroelektronikvorrichtungen nach einem der vorstehenden Ansprüche, wobei die Transistoren (101) von zwei benachbarten Mikroelektronikvorrichtungen für ein gleiches Niveau (n_{z}) einen ersten gemeinsamen Bereich (1002) aufweisen und mit zwei verschiedenen Speicherelementen (102) derart assoziiert sind, um eine 3D-Matrix von Speicherzellen zu bilden.

7. System nach dem vorstehenden Anspruch, wobei die Gitter (250) der Transistoren untereinander in einer Wortleitungszone (1) elektrisch verbunden sind und wobei die ersten Bereiche (1002) der Transistoren von zwei unterschiedlichen Niveaus (n_{z}) untereinander elektrisch isoliert sind.

8. System nach dem vorstehenden Anspruch, wobei die ersten Bereiche, vorzugsweise die Sourcen (1002), die unterschiedliche Niveaus (n_{z}) einnehmen, in einer Sourceleitungszone (3) unabhängig voneinander stufenförmig mit Kontakten (33) verbunden sind.

9. Verfahren zur Herstellung einer Mikroelektronikvorrichtung, umfassend mindestens zwei Speicherzellen (10_{x, y, z}), von denen jede einen Transistor (101) der Auswahl und ein Speicherelement (102) umfasst, das mit dem Auswahltransistor assoziiert ist, wobei jeder Transistor (101) einen Kanal (1001) in Drahtform, der sich hauptsächlich entlang einer ersten Richtung (x) erstreckt, ein Gitter (250), das an den Kanal angrenzt und sich hauptsächlich entlang einer zweiten Richtung (y) erstreckt, einen ersten Bereich, der einem von einer Source (1002) oder einem Drain (1006) entspricht, und einen zweiten Bereich, der dem anderen von der Source oder dem Drain entspricht, umfasst, der mit dem Speicherelement (102) verbunden ist, wobei die Transistoren (101) hauptsächlich entlang einer dritten Richtung (z) gestapelt sind und jeweils ein gegebenes Höhenniveau (n1, n2, n3, n4) entlang der dritten Richtung (z) einnehmen, wobei das Verfahren die folgenden Schritte umfasst:
- Bilden einer Stapelung von sich abwechselnden Schichten eines ersten Halbleitermaterials und eines zweiten dielektrischen Materials entlang der dritten Richtung (z),
- Bilden von Öffnungen (201, 202, 301, 301_{c}, 401) ausgehend von dieser Stapelung, die Transistormuster (101M) definieren, jeweils umfassend einen Mittelteil (112a), der sich hauptsächlich entlang der ersten Richtung (x) erstreckt, und erste und zweite periphere Teile (312, 112b), die sich beiderseits des Mittelteils (112a) erstrecken, wobei der Mittelteil (112a) dazu bestimmt ist, den Kanal (1001) des Transistors (101) zu bilden und die ersten und zweiten peripheren Teile (312, 112b) dazu bestimmt sind, jeweils die ersten und zweiten Bereiche des Transistors (1002, 1006) zu bilden,
- Bilden von Gittermustern (150), zum Teil in den Öffnungen (201, 202), gebietsübergreifend auf den Mittelteilen (112a) der Transistormuster (101M) und sich am Rand der ersten peripheren Teile (312) hauptsächlich entlang einer zweiten Richtung (y) erstreckend,
- Bilden von längsgerichteten Abstandshaltern (170ₛ, 170_{c}) beiderseits der Gittermuster (150), wobei die längsgerichteten Abstandshalter (170ₛ, 170_{c}) die ersten und zweiten peripheren Teile (312, 112b) der Transistormuster (101M) entlang der dritten Richtung (z) in einer Ebene (xy) hervorstehend vollständig bedecken,
- Bilden der Speicherelemente (102) derart, dass jedes Speicherelement (102) einen Rand aufweist, der entlang der dritten Richtung (z) mit einem Rand eines längsgerichteten Abstandshalters (170_{c}) ausgerichtet ist,
- Bilden der Gitter (250) der Transistoren ausgehend von den Gittermustern (150).

10. Verfahren nach dem vorstehenden Anspruch, wobei die Bildung der Stapelung die folgenden Schritte umfasst:
- Bilden, durch Epitaxie, einer provisorischen Stapelung (E) entlang der dritten Richtung (z), umfassend mindestens zwei halbleitende Schichten (12) des ersten Halbleitermaterials, getrennt durch mindestens eine Opferschicht (11) aus einem zweiten halbleitenden Material,
- nach Bildung der Gittermuster (150), Entfernen der mindestens einen Opferschicht (11) ausgehend von den Öffnungen (201, 301, 401),
- Füllen eines durch die Entfernung der mindestens einen Opferschicht (11) zurückgelassenen Raums durch das zweite dielektrische Material derart, dass mindestens eine dielektrische Schicht gebildet wird.

11. Verfahren nach dem vorstehenden Anspruch, wobei das erste Halbleitermaterial Silicium ist und das zweite Halbleitermaterial eine Silicium-Germanium-Legierung ist.

12. Verfahren nach einem der vorstehenden drei Ansprüche, wobei die Bildung der Gitter (250) die folgenden Schritte umfasst:
- Entfernen der Gittermuster (150), auch als Opfergitter bezeichnet, derart, um die in den Mittelteilen (112a) der Transistormuster (101M) gebildeten Kanäle (1001) vollständig freizulegen,
- Abscheiden eines dielektrischen Gittermaterials, danach eines metallischen Gittermaterials, derart um die Kanäle (1001) herum, dass die einkapselnden Gitter (250), die mindestens einen Kanal (1001) unter den Kanälen komplett umgeben, gebildet werden.

13. Verfahren nach dem vorstehenden Anspruch in Kombination mit einem der Ansprüche 10 und 11, wobei die mindestens eine dielektrische Schicht Abschnitte (1003) umfasst, die von der mindestens einen Opferschicht (11) am Niveau der Mittelteile (112a) der Transistormuster (101M) zwischen den Kanälen (1001) der Transistoren verbleiben und wobei diese verbleibenden Abschnitte (1003) nach der Entfernung der Gittermuster (150) und vor Bildung der Gitter (250) entfernt werden.

14. Verfahren nach einem der Ansprüche 9 bis 13, umfassend des Weiteren stufenförmige Ätzungen in einer Zone von Sourceleitungen (3) derart, um die ersten Bereiche (1002) der unterschiedlichen Niveaus (n1, n2, n3, n4) und die Bildung von stufenförmigen Kontakten (33) auf den ersten Bereichen (1002) der unterschiedlichen Niveaus (n1, n2, n3, n4) zu erzielen.

15. Verfahren nach einem der Ansprüche 9 bis 14, wobei die Bildung von Speicherelementen (102) auf dem Niveau der zweiten Bereiche (1006) durch quergerichtete Abstandshalter (170) geführt wird, die sich hauptsächlich in einer Ebene senkrecht zu der Hauptausbreitungsrichtung der längsgerichteten Abstandshalter (170c) erstrecken.

## Claims

1. A microelectronic device comprising at least two memory cells (10_{x, y, z}) each comprising a so-called selection transistor (101) and a memory element (102) associated with said selection transistor, each transistor (101) comprising a channel (1001) in the form of a wire extending mainly along a first direction (x), a gate (250) bordering said channel (1001) and extending mainly along a second direction (y), a first region corresponding to one of a source (1002) or a drain (1006), and a second region corresponding to the other of the source (1002) or the drain (1006), the second region being connected to the memory element (102), said transistors (101) being stacked mainly along a third direction (z) and each occupying a level (n1, n2, n3, n4) of a given altitude along the third direction (z), the microelectronic device being **characterized in that** the first and second regions are entirely covered by spacers (170ₛ, 170_{c}) in projection along the third direction (z) in a plane (xy).

2. The device according to the preceding claim wherein at least one of the selection transistors (101), and preferably a plurality of the selection transistors, has a so-called wrap-around gate (250), completely surrounding the channel (1001) of said selection transistor.

3. The device according to any one of the preceding claims wherein, the memory element (102) has a variable resistance, so as to form resistive memory cells (10_{x, y, z}), for example, of the OxRAM type.

4. The device according to any one of the preceding claims wherein the gates (250) of the transistors are electrically connected to each other and the first regions (1002) of the transistors are electrically insulated from each other.

5. The device according to any one of the preceding claims wherein the first regions (1002) of the transistors extend mainly along the second direction (y) normal to the first direction (x).

6. A microelectronic system comprising a plurality of microelectronic devices according to any one of the preceding claims connected to each other, the transistors (101) of two adjacent microelectronic devices having a common first region (1002) for a same level (n_{z}) and being associated with two separate memory elements (102), so as to form a 3D matrix of memory cells.

7. The system according to the preceding claim wherein the gates (250) of the transistors are electrically connected to each other in a word line (1) zone, and wherein the first regions (1002) of the transistors of two different levels (n_{z}) are electrically insulated from each other.

8. The system according to the preceding claim wherein the first regions, preferably the sources (1002), occupying different levels (n_{z}) are connected in a staircase form to contacts (33), independently of each other, in a source line zone (3).

9. A method of manufacturing a microelectronic device comprising at least two memory cells (10_{x, y, z}) each comprising a so-called selection transistor (101) and a memory element (102) associated with said selection transistor, each transistor (101) comprising a channel (1001) in the form of a wire extending mainly along a first direction (x), a gate (250) bordering said channel and extending mainly along a second direction (y), a first region corresponding to one of a source (1002) or a drain (1006) and a second region corresponding to the other of the source or the drain connected to the memory element (102), said transistors (101) being stacked mainly along a third direction (z) and each occupying a level (n1, n2, n3, n4) of given altitude along the third direction (z), the method comprising the following steps:
- Forming a stack along the third direction (z) of alternate layers of a first semiconductor material and a second dielectric material,
- Forming from this stack openings (201, 202, 301, 301_{c}, 401) defining transistor patterns (101M) each comprising a central portion (112a) extending mainly along a first direction (x) and first and second peripheral portions (312, 112b), extending on either side of the central portion (112a), said central portion (112a) being intended to form the channel (1001) of the transistor (101) and said first and second peripheral portions (312, 112b) being intended to form respectively the first and second regions (1002, 1006) of the transistor,
- Forming gate patterns (150) in part within the openings (201, 202), spanning the central portions (112a) of the transistor patterns (101M) and extending mainly along a second direction (y) at the edge of the first peripheral portions (312),
- Forming longitudinal spacers (170ₛ, 170_{c}) on either side of the gate patterns (150), said longitudinal spacers (170ₛ, 170_{c}) covering entirely the first and second peripheral portions (312, 112b) of the transistor patterns (101M) in projection along the third direction (z) in a plane (xy),
- Forming the memory elements (102) so that each memory element (102) has an edge in line with, along the third direction (z), an edge of a longitudinal spacer (170_{c}),
- Forming the gates (250) of the transistors from the gate patterns (150).

10. The method according to the preceding claim wherein the formation of the stack comprises the following steps:
- Forming by epitaxy a provisional stack (E) along the third direction (z) comprising at least two semiconductor layers (12) of the first semiconductor material separated by at least one sacrificial layer (11) in a second semiconductor material,
- After forming the gate patterns (150), removing the at least one sacrificial layer (11) from said openings (201, 301, 401),
- Filling by the second dielectric material a space left by the removal of the at least one sacrificial layer (11), so as to form at least one dielectric layer.

11. The method according to the preceding claim wherein the first semiconductor material is silicon, and the second semiconductor material is an alloy of silicon-germanium.

12. The method according to any one of the three preceding claims wherein the formation of the gates (250) comprises the following steps:
- Removing the gate patterns (150), also called sacrificial gates, so as to entirely clear the channels (1001) formed in the central portions (112a) of the transistor patterns (101M),
- Depositing a gate dielectric material then a gate metallic material around said channels (1001) so as to form so-called wrap-around gates (250) completely surrounding at least one channel (1001) of said channels.

13. The method according to the preceding claim combined with any one of the two claims 10 and 11 wherein the at least one dielectric layer comprises remaining portions (1003) of the at least one sacrificial layer (11) at the central portions (112a) of the transistor patterns (101M) between the channels (1001) of the transistors and wherein these remaining portions (1003) are removed after removing the gate patterns (150) and before forming the gates (250).

14. The method according to one of claims 9 to 13 further comprising staircase etchings in a source line zone (3), so as to reach the first regions (1002) of the different levels (n1, n2, n3, n4), and the formation of contacts (33) in staircase form on the first regions (1002) of the different levels (n1, n2, n3, n4).

15. The method according to any one of claims 9 to 14 wherein the formation of the memory elements (102) at the second regions (1006) is guided by transversal spacers (170) extending mainly in a plane normal to the main extension direction of the longitudinal spacers (170_{c}).
